# EUROPÄISCHE PATENTSCHRIFT

(11) **EP 3 339 901 B1**
(45) Veröffentlichungstag und Bekanntmachung des Hinweises auf die Patenterteilung: **24.04.2019**
(21) Anmeldenummer: 16206010.7
(22) Anmeldetag: 21.12.2016
(51) Int. Cl.: G01S 17/10, G01S 7/486, H03M 1/06

(54) **LASERDISTANZMESSMODUL MIT ADC-FEHLERKOMPENSATION DURCH VARIATION DER SAMPLINGZEITPUNKTE**
LASER DISTANCE MEASURING MODULE WITH ADC ERROR COMPENSATION BY VARYING SAMPLING TIMES
MODULE TÉLÉMÉTRIQUE LASER COMPRENANT UNE COMPENSATION D'ERREUR ADC PAR VARIATION DES MOMENTS D'ÉCHANTILLONNAGE

(43) Veröffentlichungstag der Anmeldung: 27.06.2018
(73) Patentinhaber: Hexagon Technology Center GmbH, 9435 Heerbrugg (CH)
(72) Erfinder: WOHLGENANNT, Rainer, A-6833 Klaus (AT); BESTLER, Simon, D-88085 Langenargen (DE); HINDERLING, Jürg, CH-9437 Marbach (CH)
(74) Vertreter: Kaminski Harmann

(56) Entgegenhaltungen:
- EP-B1- 1 832 897
- US-A1- 2011 098 970
- US-A1- 2014 368 364

## Beschreibung

Die vorliegende Erfindung betrifft eine Distanzmessmethode und ein elektronisches Laserdistanzmessmodul, insbesondere zur Verwendung in einem Distanzmessgerät, z.B. in einem Lasertracker, Tachymeter, Laserscanner, oder Profiler, zur schnellen Signalerfassung mit einem Analog-Digital-Wandler (ADC), wobei im Rahmen einer Signal-Digitalisierung entstehende Umwandlungsfehler, insbesondere Timing-, Gain- und Offset-Fehler des ADC, mittels Variation der Samplingzeitpunkte kompensiert werden.

Im Bereich der elektronischen bzw. elektrooptischen Distanzmessung sind verschiedene Prinzipien und Verfahren bekannt. Ein Ansatz besteht darin, gepulste elektromagnetische Strahlung, wie z.B. Laserlicht, auf ein zu vermessendes Ziel auszusenden und nachfolgend ein Echo von diesem Ziel als rückstreuendem Objekt zu empfangen, wobei die Distanz zum zu vermessenden Ziel beispielsweise anhand der Laufzeit, der Form, und/oder der Phase des Pulses bestimmt werden kann. Solche Laserdistanzmesser haben sich mittlerweile in vielen Bereichen als Standardlösungen durchgesetzt.

Zur Detektion des zurückgestreuten Pulses werden zumeist zwei unterschiedliche Ansätze oder eine Kombination daraus verwendet.

Bei der so genannten Schwellwertmethode wird ein Lichtpuls detektiert, wenn die Intensität der auf einen Detektor des eingesetzten Distanzmessgeräts einfallenden Strahlung einen gewissen Schwellwert überschreitet. Durch diesen Schwellwert wird verhindert, dass Rauschen und Störsignale aus dem Hintergrund fälschlich als Nutzsignal, d.h. als rückgestreutes Licht des emittierten Pulses, detektiert werden.

Der andere Ansatz basiert auf der Abtastung bzw. dem Sampling des rückgestreuten Pulses. Dieser Ansatz wird typischerweise bei schwachen rückgestreuten Signalen (z.B. Pulssignale) verwendet, wie sie beispielsweise durch grössere Messdistanzen bedingt werden, oder allgemein für eine Erhöhung der Messgenauigkeit. Ein emittiertes Signal wird detektiert, indem die von einem Detektor erfasste Strahlung abgetastet, innerhalb des abgetasteten Bereichs ein Signal identifiziert und schliesslich eine Lage des Signals zeitlich bestimmt wird. Durch die Verwendung einer Vielzahl von Abtastwerten und/oder zur Emissionsrate synchronem Aufsummieren des Empfangssignals kann ein Nutzsignal auch unter ungünstigen Umständen identifiziert werden, so dass auch grössere Distanzen oder verrauschte bzw. mit Störungen behaftete Hintergrundszenarien bewältigt werden können.

### Heutzutage wird dabei mittels der

Wellenformdigitalisierungsmethode ("Waveform Digitizing", WFD) häufig die gesamte Wellenform des analogen Signals der von einem Detektor erfassten Strahlung abgetastet. Nach Identifikation der Codierung des zugehörigen Sendesignals (ASK, FSK, PSK, etc.) eines empfangenen Signals, wird aus einem definierten Verlaufspunkt des abgetasteten, digitalisierten und rekonstruierten Signals, beispielsweise den Wendepunkten, den Kurvenmaxima, oder integral mittels eines aus der Zeitinterpolation bekannten Optimum Filters, sehr genau eine Signallaufzeit ("Pulslaufzeit") bestimmt.

Alternativ oder zusätzlich zur Bestimmung der Pulslaufzeit erfolgt eine (schnelle) Abtastung oft auch hinsichtlich in Amplitude, Phase, Polarisation, Wellenlänge und/oder Frequenz codierten oder modulierten Impulsen oder Impulsfolgen.

Beim Ansatz der zeitlich sehr präzisen Abtastung bzw. dem Sampling des zurückgestreuten Signals wird das vom Detektor erzeugte elektrische Signal mittels eines Analog-Digital-Wandlers ("Analog-Digital-Converter", ADC) in eine digitale Signalfolge umgewandelt. Dieses digitale Signal wird anschliessend meistens in Echtzeit weiter verarbeitet. In einem ersten Schritt wird das Signal, oft als Impuls moduliert, durch spezielle digitale Filter erkannt und schliesslich dessen Lage innerhalb der Signalfolge bestimmt. Durch die Verwendung einer Vielzahl von abgetasteten Impulsfolgen kann ein Nutzsignal auch unter ungünstigen Umständen identifiziert werden, so dass auch grössere Distanzen oder verrauschte bzw. mit Störungen behaftete Hintergrundszenarien bewältigt werden können.

Eine der einfachsten Modulationsarten ist die Kennzeichnung der einzelnen Impulse oder der Pulsfolgen per Abstandscodierung, wie z.B. beschrieben in der EP 1 832 897 B1. Diese wird beispielsweise zu dem Zwecke der Re-Identifizierbarkeit eingesetzt. Diese Wiedererkennung ist dann erforderlich, wenn eine Mehrdeutigkeit entsteht, welche bei der Laufzeitmessung von Impulsen durch unterschiedliche Situationen hervorgerufen werden kann, beispielsweise wenn sich zwischen Vermessungsgerät und Zielobjekt mehr als ein Impuls oder eine Impulsgruppe befindet.

Bei schnellen Analog-Digital-Wandlern (ADC) wird die hohe Abtastrate in Verbindung mit einer hohen Auflösung der Signalamplitude (z.B. 1GS/s, 14bit) beispielsweise erreicht durch die Erzeugung mehrere ADC-Wandlungsstufen, beispielsweise durch:
- ein zeitliches Verschachteln ("interleave", "interleaving") mehrerer langsamer ADC-Wandlungsstufen,
- ein stufenweises Quantisieren der abgetasteten Signalamplituden ("pipeline", "pipelining"), oder
- kombiniert ein mehrstufiges Quantisieren der Signalabtastwerte von mehreren ADC-Wandlungsstufen

Bei diesen Architekturen entstehen trotz sorgfältiger interner Korrekturen architekturtypische Fehler. Diese Fehler variieren über Zeit und Temperatur.

Bei interleaved ADCs entstehen die Fehler insbesondere dadurch, dass die verschiedenen ADC-Wandlungsstufen nicht exakt identische Eigenschaften in Bezug auf Offset, Verstärkung und Timing haben. Dadurch wirken sich die typischen Fehler insbesondere aus als:
- Skew (Timing-Fehler zwischen den Sample-Zeitpunkten der unterschiedlichen ADC-Wandlungsstufen oder ADCs);
- Gain (unterschiedlicher Verstärkungsfaktor zwischen den internen ADC-Kernbausteinen. Das Signal wird meist verstärkt und/oder gepuffert im ADC);
- Offset (unterschiedliche DC Level der internen Ausgänge der ADC Wandlungsstufen).

Bei pipelined ADCs wirken sich die typischen Fehler meist als Differentielle Nichtlinearität DNL und Integrale Nichtlinearität INL aus. DNL und INL sind Fehler bei der Umwandlung der analogen Signalwerte in digitale (ganzzahlige) Werte, beispielsweise hervorgerufen durch das stufenweise Quantisieren bei einem Pipeline-ADC in immer feiner werdende Schritte/immer grösser werdende Auflösung.

Der INL-Fehler ist im Wesentlichen die Teilsumme aller Beiträge der unter dem zu wandelnden Signalpegel liegenden DNL-Fehler und kann mehrere LSB ("Least Significant Bit") erreichen. Besonders der INL-Fehler hat deshalb bereits bei mässigen Schwankungen der Signalwerte gravierende Auswirkungen auf die digitalisierte Signalformgenauigkeit. Die digitalisierte Signalform entspricht nicht mehr der ursprünglichen analogen Signalform. Durch interne Korrekturen im ADC-Bauteil können diese DNL- und INL-Fehler teilweise minimiert, jedoch nicht eliminiert, werden und eine externe Kalibration, welche durch Messen und Aufzeichnen des Restfehlers bewerkstelligt werden kann, ist zeitlich variabel und beispielsweise stark temperaturabhängig.

Bei der Distanzmessung entstehen durch die Fehler der einzelnen ADC-Wandlungsstufen über Distanz periodische Distanzfehler im Abstand des Abtast-/Samplerasters. Die Flanken eines digitalen Signalpulses sind durch die Wandlungsfehler in der Auslenkung verfälscht, wodurch die Position des Signalpulses zur Zeitachse verschoben sein kann. Auch bei Distanzmesssystemen mit Start- und Stopp-Impulsen oder Start- und Stopp-Signalfolgen können Fehler bei der Messdistanz auftreten. Zum Beispiel ist dies dann der Fall, wenn der Startpuls eine Amplitude im mittleren Aussteuerbereich hat, wohingegen der Stopppuls eine Amplitude im unteren Amplitudenbereich hat, wobei beispielsweise durch eine INL-bedingte Formverzerrung beide Pulse unterschiedlich deformiert und die Absolutdistanz verfälscht wird.

Es ist deshalb eine Aufgabe der Erfindung, eine verbesserte Distanzmessung mit einer gleichzeitig hohen Messgenauigkeit und einer hohen Distanzauflösung bereitzustellen.

Eine spezielle Aufgabe der Erfindung liegt dabei darin, eine verbesserte Methode und ein verbessertes System für die Signal-Digitalisierung zur Verfügung zu stellen.

Eine weitere spezielle Aufgabe der Erfindung liegt zudem darin, eine verbesserte Fehlerkompensation bei schnellen ADCs bereitzustellen, insbesondere für interleaved ADCs.

Diese Aufgaben werden durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Die Erfindung betrifft eine Distanzmessmethode, insbesondere für ein Laser-Distanzmessgerät, im Speziellen ausgebildet als Lasertracker, Tachymeter, Laserscanner, oder Profiler, zur Bestimmung einer Distanz zu einem Zielobjekt mit einem Aussenden von Sendesignalen, insbesondere gepulsten Sendesignalen, als Sendesignalreihe; einem Empfangen von zumindest Teilen der am Zielobjekt reflektierten Sendesignale der Sendesignalreihe als Empfangssignale einer Empfangssignalreihe; einem Digitalisieren der Empfangssignale der Empfangssignalreihe in Digitalsignale einer Digitalsignalreihe mittels eines Analog-Digital-Wandlers, nachfolgend ADC genannt, insbesondere vom Typ Interleaved-ADC oder Pipelined-ADC, mit einem durch mindestens zwei ADC-Wandlungsstufen erzeugten ADC-Abtastraster; und einem Verarbeiten der Digitalsignalreihe um daraus die Distanz zum Zielobjekt abzuleiten; insbesondere wobei die Bestimmung der Distanz auf dem Pulslaufzeitverfahren basiert.

Unmittelbar nach dem Start einer Aufnahme eines Empfangssignals liefert der ADC laufend Digitalwerte die jeweils einen zeitlichen Abstand einer Taktperiode aufweisen, dieses hardware-bedingte ADC-Abtastraster definiert ein initiales Signalabtastraster eines Empfangssignals. Das Sendesignal wird mehrmals oder repetitiv wiederholt, diese Sendesignalreihe wird zeitlich fortlaufend verschoben abgetastet und es entstehen sekundäre Signalabtastraster. Diese mehreren sekundären digitalen Empfangssignale zeigen unterschiedliche relative zeitliche Positionen innerhalb des ADC-Taktintervalls. Ist der Quotient der zeitlichen Verschiebung zum Taktintervall eine rationale Zahl, so wiederholt sich die Überabtastung nach einer definierten Zeit und umfasst eine definierte Anzahl von mit gleicher Phase abgetasteten Empfangssignalen. Dies hat den Vorteil, dass diese gleichartigen Signale gemeinsam verarbeitet, beispielsweise akkumuliert, werden können und anschliessend in der Auswertung als ein einziges feinabgetastetes Empfangssignal behandelt werden können. Die Fehler durch ADC-Wandlungsfehler heben sich dabei weitgehend auf, wobei insbesondere entscheidend ist, die relative zeitliche Verschiebung des Sendepulses zum Samplingraster im Kontext der Anzahl ADC-Wandlungstufen zu sehen, beispielsweise in dem Sinn, dass identische Abtastpunkte der Sendepulse von mehreren ADC-Wandlungsstufen erfasst werden.

Eine alternative Auswertemethode ist die Verarbeitung, insbesondere Akkumulation, basierend auf allen initialen und sekundären Digitalsignalfolgen in der Art, dass die korrespondierenden Samples aller sekundären Digitalsignale die weniger als plus/minus ein halbes Taktintervall zu den Samples des initialen Digitalsignals verschoben liegen verarbeitet (z.B. akkumuliert) werden und dadurch beispielsweise eine Mittelung erfolgt, welche die Fehlereinflüsse des ADCs oder einzelner ADC-Wandlungsstufen stark reduziert. Diese Auswertemethode ist auch zielführend, falls der Quotient der zeitlichen Verschiebung zum Taktintervall eine irrationale Zahl ist. Diese Auswertemethode funktioniert daher bei allen Einstellungen der Asynchronität zwischen dem Clock der Sendeeinheit und dem Clock der Empfangselektronik.

Gemäss der vorliegenden Erfindung wird durch das ADC-Abtastraster bezüglich eines Empfangssignals ein initiales Signalabtastraster mit mindestens einem initialen Abtastpunkt des Empfangssignals definiert (wobei die Taktperiode des initialen Signalabtastrasters typischerweise durch einen hardware-bedingten Arbeitszyklus der ADC-Wandlungsstufen gegeben ist), und die Empfangssignale der Empfangssignalreihe relativ zum ADC-Abtastraster mittels einer ersten zeitlichen Verschiebung derart zeitlich verschoben, dass der mindestens eine initiale Abtastpunkt mindestens einmal durch eine erste ADC-Wandlungsstufe und mindestens einmal durch eine zweite ADC-Wandlungsstufe erfasst wird; insbesondere wobei die Empfangssignale der Empfangssignalreihe relativ zum ADC-Abtastraster mittels einer zweiten zeitlichen Verschiebung zusätzlich zeitlich verschoben werden, dass in einem definierten Abtastbereich um den mindestens einen initialen Abtastpunkt eine Vielzahl von sekundären jeweils um einen Bruchteil der Periodendauer des ADC-Taktes verschobenen Abtastpunkten der Empfangssignale entstehen und dadurch unterschiedliche Signalpositionen um den mindestens einen initialen Abtastpunkt mit variierendem Signalwert abgetastet werden.

ADC-Wandlungsfehler, beispielsweise Timing-, Gain-, Offset- oder INL-Fehler, können lokal mit der ADC-Abtastfolge sehr stark variieren, wodurch ein Distanzmessfehler entsteht, der periodisch ist mit der ADC-Abtastfolge.

Durch die Vielzahl von Abtastungen von unterschiedlichen Signalpositionen mit variierender Amplitude (Signalstärke) des jeweils digitalisierten Signalwertes wird das eigentliche ADC-Messsignal um den mindestens einen initialen Abtastpunkt über einen Wertebereich geschoben, wodurch verschiedene signalwertabhängige Fehlerzonen eines ADC-Wandlungsfehlers überstrichen werden. Durch die Verarbeitung mehrerer Empfangssignale, beispielsweise eine Mittelung oder ein Aufsummieren, und somit einer Vielzahl sekundärer Abtastungen um den initialen Abtastpunkt, entsteht so automatisch eine Mittelung über unterschiedliche Fehlerbeiträge von ADC-Wandlungsfehlern.

Durch die Abtastung des mindestens einen initialen Abtastpunkts und gegebenenfalls der sekundären Abtastungen (sekundäre Abtastpunkte) durch mehrere ADC-Wandlungsstufen ("Vermischung der ADC-Wandlungsstufen") vermischen sich die Fehlerbeiträge der ADC-Wandlungsstufen beispielsweise im Abtastbereich um den initialen Abtastpunkt, womit bereits nach wenigen Signalpulsen und nach kurzer Messzeit eine ausreichende Fehlerauslöschung gewährleistet ist.

In einer speziellen Ausführungsform werden die Sendesignale basierend auf einem Sende-Clock (mit einer festen Sende-Clockfrequenz) ausgesendet und die Empfangssignale basierend auf einem ADC-Clock erfasst, wobei im Rahmen eines Messvorgangs mindestens eine der folgenden Bedingungen erfüllt ist: der Sende-Clock ist asynchron zum ADC-Clock; die Periodendauer des Sende-Clocks und/oder eine Periodendauer der Sendesignale ist unterschiedlich zur Periodendauer des ADC-Taktes oder zu einem ganzzahligen Vielfachen der Periodendauer des ADC-Taktes; und die der Sende-Clockfrequenz und/oder einer Wiederholrate der Sendesignale fₛ entsprechende Sende-Periode Tₛ (= 1 / fₛ) ist gegeben als Tₛ = (n + q) * T_{ADC}, wobei n eine ganze Zahl ist, q eine gebrochene Zahl mit Betrag < 1 und T_{ADC} die Periodendauer des ADC-Taktes (die der ADC-Taktfrequenz f_{ADC} entsprechende ADC-Abtastperiode T_{ADC} = 1/f_{ADC}), wobei für eine Anzahl verwendeter ADC-Wandlungsstufen c die Bedingung n modulo c ≠ 0 erfüllt ist.

Wie oben beschrieben, hängt eine Kompensation der Fehler durch ADC-Wandlungsfehler entscheidend davon ab, dass identische Abtastpunkte der Sendepulse - bestenfalls mehrmals - von mehreren ADC-Wandlungsstufen erfasst werden, wodurch sich die ADC-Wandlungsfehler weitgehend aufheben. Insbesondere ist also entscheidend, die relative zeitliche Verschiebung des Sendepulses zum Samplingraster im Kontext der Anzahl ADC-Wandlungstufen zu sehen.

Eine weitere Ausführungsform der Erfindung ist deshalb dadurch gekennzeichnet, dass die Empfangssignale der Empfangssignalreihe relativ zum ADC-Abtastraster mit einer definierten Anzahl erster zeitlicher Verschiebungen verschoben werden, wobei die Anzahl erster zeitlicher Verschiebungen eingestellt wird basierend auf mindestens einem Element der folgenden Gruppe: einer definierten minimalen Anzahl Abtastungen des mindestens einen initialen Abtastpunkts durch jede der verwendeten ADC-Wandlungsstufen; einer definierten Messgenauigkeit für die Bestimmung der Distanz; einem gemessenen Signalwert des Empfangssignals; und einer vorgegebenen Messzeit.

Ein mittlerer ADC-Wandlungsfehler kann beispielsweise als Funktion eines mittleren Signalwerts über unterschiedliche Wertebereiche variieren, z.B. in dem Sinne, dass der (lokale) ADC-Wandlungsfehler beispielsweise für einen Bereich mit einer höheren mittleren Amplitude grösser ist als für einen Bereich niedrigerer mittlerer Amplitude. Des Weiteren hängt die Minimierung des lokalen Fehlers, also auch die erreichte Distanzmessgenauigkeit, entscheidend vom Wertebereich ab, über den das eigentliche Messsignal variiert (und somit gemittelt) wird.

Eine weitere Ausführungsform ist deshalb dadurch gekennzeichnet, dass die Empfangssignale der Empfangssignalreihe relativ zum ADC-Abtastraster mit einer definierten Anzahl zweiter zeitlicher Verschiebungen verschoben werden, wodurch der Abtastbereich mit einer definierten Anzahl sekundärer Abtastpunkte abgetastet wird, wobei die Anzahl sekundärer Abtastpunkte eingestellt wird basierend auf mindestens einem Element der folgenden Gruppe: einer definierten minimalen Anzahl sekundärer Abtastpunkte, insbesondere basierend auf einer minimalen Anzahl Abtastungen jedes sekundären Abtastpunkts durch jede der verwendeten ADC-Wandlungsstufen; einer definierten Messgenauigkeit für die Bestimmung der Distanz; einem gemessenen Signalwert des Empfangssignals; und einer vorgegebenen Messzeit.

Ein weiterer Aspekt betrifft insbesondere Distanzmessungen basierend auf dem "Start-Stop"-Prinzip, wo sowohl die Signalfolge des ausgesendeten Pulses als auch die Empfangssignalfolge des reflektierten Pulses abgetastet wird und im Rahmen der Distanzmessung berücksichtigt wird. Dahingegen ist bei "Stop-Only" Messungen der Zeitpunkt des Aussendens des Sendepulses bekannt, beispielsweise durch einen System-Clock, wobei nur das reflektierte Signal der Empfangssignalfolge abgetastet wird.

Bei der Messmethode mit Start-Stop Abtastung können durch die bekannte Verschiebung des Sendezeitpunktes, beispielsweise basierend auf einem System-Clock, und einer zusätzlichen Bestimmung des Sendezeitpunktes durch eine Abtastung eines Sendesignals oder der Sendesignalreihe allfällige, nicht kompensierte oder nicht kompensierbare Restfehler, insbesondere Timing-Fehler, bestimmt werden und dadurch zusätzliche Korrekturen im Rahmen der Bestimmung des Zeitpunktes beziehungsweise der Distanz, abgeleitet aus der Empfangssignalfolge des reflektierten Pulses, angewendet werden.

Eine weitere spezielle Ausführungsform der Erfindung bezieht sich folglich beispielsweise darauf, dass zumindest Teile der Sendesignale als Referenzsignale einer Referenzsignalreihe über eine Referenzstrecke mit bekannter, unveränderlicher Länge verlaufen und mittels des ADC digitalisiert werden, insbesondere mittels Reflektion am Zielobjekt in einem bekannten, unveränderlichen Abstand oder ohne vorherige Reflektion am Zielobjekt, im Speziellen wobei die Referenzstrecke komplett innerhalb des Laser-Distanzmessgeräts verläuft, wobei das ADC-Abtastraster bezüglich eines Referenzsignals ein initiales Referenzabtastraster mit mindestens einem initialen Referenz-Abtastpunkt des Referenzsignals definiert und die Referenzsignale der Referenzsignalreihe relativ zum ADC-Abtastraster mittels der ersten zeitlichen Verschiebung verschoben werden, sodass der mindestens eine initiale Referenz-Abtastpunkt mindestens einmal durch die erste ADC-Wandlungsstufe und mindestens einmal durch die zweite ADC-Wandlungsstufe erfasst wird; insbesondere wobei die Referenzsignale der Referenzsignalreihe relativ zum ADC-Abtastraster mittels der zweiten zeitlichen Verschiebung zusätzlich zeitlich verschoben werden, dass in einem definierten Abtastbereich um den mindestens einen initialen Referenz-Abtastpunkt eine Vielzahl von sekundären jeweils um einen Bruchteil der Periodendauer des ADC-Taktes verschobenen Referenz-Abtastpunkten der Referenzsignale entstehen und dadurch unterschiedliche Signalpositionen um den mindestens einen initialen Referenz-Abtastpunkt mit variierendem Signalwert abgetastet werden.

Aufgrund dieser Referenzabtastung kann basierend auf den digitalisierten Referenzsignalen ein Referenz-Sendezeitpunkt für die Sendesignalreihe abgeleitet werden; basierend auf einem System-Clock ein System-Sendezeitpunkt für die Sendesignalreihe abgeleitet werden; und basierend auf dem Referenz-Sendezeitpunkt und dem System-Sendezeitpunkt eine Referenz-Zeitinformation für eine Bestimmung der ersten und/oder zweiten zeitlichen Verschiebung abgeleitet werden, welche bei einer Bestimmung eines Empfangszeitpunkts der Empfangssignalreihe und/oder der Bestimmung der Distanz zum Zielobjekt berücksichtigt wird.

In einer weiteren Ausführungsform werden die relativen zeitlichen Verschiebungen erzeugt mittels eines Verschiebens der Sendezeitpunkte der Sendesignale und/oder mittels eines Verschiebens der Abtastzeitpunkte der Empfangssignale.

Bei vielen Distanzmessmethoden, beispielsweise auch mittels WFD, werden periodisch einzelne Laserpulse oder Gruppen von kurzen Laserpulsen emittiert. Zum Beispiel liegt die Pulsrate bei einigen kHz bis mehreren MHz, wobei die Pulsrate beispielsweise von einem höherfrequenten Oszillator abgeleitet wird, von welchem auch die Taktfrequenz des Analog-Digital-Wandlers abgeleitet wird. Mittels eines digitalen Phasenschiebers im Triggerkanal der Sendeeinheit kann die zeitliche Verschiebung des Aussendezeitpunkts des Lasersignals eingestellt werden.

Bekannt sind zum Beispiel elektronische Phasenschieberbausteine bei 12GHz mit vier bis acht Bit Phasenauflösung, und einer Phasenstabilität besser als vier Grad was bei 12 GHz beispielsweise einem Zeitjitter von 0.9 psec entspricht.

Die zeitliche Verschiebung des Sendesignals zur Empfängereinheit kann somit einfach eingestellt und variiert werden. Bei kurzen Messzeiten, wo nur wenige Signalfolgen aufgenommen werden, könnte der Zeitjitter nach der Phasenschiebeeinheit zu gross sein. Dieser lässt sich aber beispielsweise mittels eines nachgeschalteten PLL (Phaselocked Loop) ausreichend verringern.

Eine weitere Ausführungsform bezieht sich darauf, dass die Sendesignale basierend auf einem Sende-Clock (mit einer festen Sende-Clockfrequenz) ausgesendet werden und relativ zum Sende-Clock ein initialer relativer Aussendezeitpunkt eines Sendesignals definiert ist, und/oder die Empfangssignale basierend auf einem Empfangs-Clock (mit einer festen Empfangs-Clockfrequenz) erfasst werden und durch den Empfangs-Clock ein ADC-Clock für die Steuerung des ADC zur Erfassung einer Folge von Empfangssignalen definiert ist, wobei mittels eines ersten Phasenschiebers mindestens ein zum initialen relativen Aussendezeitpunkt zeitlich verschobener sekundärer relativer Aussendezeitpunkt des Sendesignals erzeugt wird, und/oder mittels eines zweiten Phasenschiebers der ADC-Clock relativ zum Empfangs-Clock zeitlich verschoben wird.

Die Erfindung betrifft weiter ein elektronisches Laserdistanzmessmodul, insbesondere zur Verwendung in einem Distanzmessgerät, im Speziellen ausgebildet als Lasertracker, Tachymeter, Laserscanner, oder Profiler, für eine Bestimmung einer Distanz zu einem Zielobjekt mit einem optischen Sendekanal mit einer Sendeeinheit zur Erzeugung von Sendesignalen einer Sendesignalreihe, insbesondere mittels gepulster Lasermessstrahlung; einem optischen Empfangskanal mit einer Empfangseinheit zum Empfang von zumindest Teilen der am Zielobjekt reflektierten Sendesignale der Sendesignalreihe als Empfangssignale einer Empfangssignalreihe; einer Empfangsschaltung für eine Digitalisierung der Empfangssignale der Empfangssignalreihe in Digitalsignale einer Digitalsignalreihe mit einem Analog-Digital-Wandlers, nachfolgend ADC genannt, insbesondere vom Typ Interleaved-ADC oder Pipelined-ADC, mit einem durch mindestens zwei ADC-Wandlungsstufen erzeugten ADC-Abtastraster; und einer Kontroll- und Steuereinheit für eine Bestimmung der Distanz zum Zielobjekt basierend auf einer Verarbeitung der Digitalsignalreihe; insbesondere wobei die Bestimmung der Distanz auf dem Pulslaufzeitverfahren basiert.

Gemäss der vorliegenden Erfindung ist das Laserdistanzmessmodul derart ausgebildet, dass das ADC-Abtastraster bezüglich eines Empfangssignals ein initiales Signalabtastraster mit mindestens einem initialen Abtastpunkt des Empfangssignals definiert und die Empfangssignale der Empfangssignalreihe relativ zum ADC-Abtastraster mittels einer ersten zeitlichen Verschiebung derart zeitlich verschoben werden, dass der mindestens eine initiale Abtastpunkt mindestens einmal durch eine erste ADC-Wandlungsstufe und mindestens einmal durch eine zweite ADC-Wandlungsstufe erfasst wird; insbesondere wobei die Empfangssignale der Empfangssignalreihe relativ zum ADC-Abtastraster mittels einer zweiten zeitlichen Verschiebung zusätzlich zeitlich verschoben werden, dass in einem definierten Abtastbereich um den mindestens einen initialen Abtastpunkt eine Vielzahl von sekundären jeweils um einen Bruchteil der Periodendauer des ADC-Taktes verschobenen Abtastpunkten der Empfangssignale entstehen und dadurch unterschiedliche Signalpositionen um den mindestens einen initialen Abtastpunkt mit variierendem Signalwert abgetastet werden.

Zum Beispiel können die Sendeeinheit und die Empfangseinheit derart ausgebildet sein, dass ein Laserpuls-Trigger und ein ADC-Clock asynchron von zwei unabhängigen Clock-Generatoren erzeugt werden. Alternativ können beispielsweise der Laserpuls-Trigger und der ADC-Clock aus demselben Clock-Generator erzeugt werden, zum Beispiel mittels einer oder mehrerer Phasenregelschleifen (PLL, z.B. Integer-PLL oder Fractional-PLL).

Weiter können die Samplingzeitpunkte beispielsweise durch einstellbare (sehr kleine) Verzögerungen variiert werden, beispielsweise mittels eines Phasenschiebers, wobei zum Beispiel die Frequenz des ADC-Clocks einem Vielfachen der Frequenz des Sendeclocks entspricht.

Gemäss einer weiteren Ausführungsform ist das Laserdistanzmessmodul derart ausgestaltet, dass die Sendesignale basierend auf einem Sende-Clock ausgesendet werden und die Empfangssignale basierend auf einem ADC-Clock erfasst werden, wobei im Rahmen eines Messvorgangs mindestens eine der folgenden Bedingungen erfüllt ist: der Sende-Clock ist asynchron zum ADC-Clock; die Periodendauer des Sende-Clocks und/oder eine Periodendauer der Sendesignale ist unterschiedlich zur Periodendauer des ADC-Taktes oder einem ganzzahligen Vielfachen der Periodendauer des ADC-Taktes; und die der Sende-Clockfrequenz und/oder einer Wiederholrate der Sendesignale entsprechende Sende-Periode Tₛ ist gegeben als Tₛ = (n + q) * T_{ADC}, wobei n eine ganze Zahl ist, q eine gebrochene Zahl zwischen -1 und +1 und T_{ADC} die Periodendauer des ADC-Taktes, wobei für eine Anzahl verwendeter ADC-Wandlungsstufen c die Bedingung n modulo c ≠ 0 erfüllt ist.

In einer speziellen Ausführungsform ist das Laserdistanzmessmodul derart ausgestaltet, dass die Empfangssignale der Empfangssignalreihe relativ zum ADC-Abtastraster mit einer definierten Anzahl erster zeitlicher Verschiebungen verschoben werden, wobei die Anzahl erster zeitlicher Verschiebungen eingestellt wird, basierend auf mindestens einem Element der folgenden Gruppe: einer definierten minimalen Anzahl Abtastungen des mindestens einen initialen Abtastpunkts durch jede der verwendeten ADC-Wandlungsstufen; einer definierten Messgenauigkeit für die Bestimmung der Distanz; einem gemessenen Signalwert des Empfangssignals; und einer vorgegebenen Messzeit.

Insbesondere ist das Laserdistanzmessmodul gemäss einer weiteren Ausführungsform derart ausgebildet, dass die Empfangssignale der Empfangssignalreihe relativ zum ADC-Abtastraster mit einer definierten Anzahl zweiter zeitlicher Verschiebungen verschoben werden, wodurch der Abtastbereich mit einer definierten Anzahl sekundärer Abtastpunkte abgetastet wird, wobei die Anzahl sekundärer Abtastpunkte eingestellt wird basierend auf mindestens einem Element der folgenden Gruppe: einer definierten minimalen Anzahl von zueinander unterschiedlicher sekundärer Abtastpunkte, insbesondere basierend auf einer minimalen Anzahl Abtastungen jedes sekundären Abtastpunkts durch jede der verwendeten ADC-Wandlungsstufen; einer definierten Messgenauigkeit für die Bestimmung der Distanz; einem gemessenen Signalwert des Empfangssignals; und einer vorgegebenen Messzeit.

In einer weiteren Ausführungsform ist das Laserdistanzmessmodul derart ausgebildet, dass zumindest Teile der Sendesignale als Referenzsignale einer Referenzsignalreihe über eine Referenzstrecke mit bekannter, unveränderlicher Länge verlaufen und mittels des ADC digitalisiert werden, insbesondere mittels Reflektion am Zielobjekt in einem bekannten, unveränderlichen Abstand oder ohne vorherige Reflektion am Zielobjekt, im Speziellen wobei die Referenzstrecke komplett innerhalb des Laser-Distanzmessgeräts verläuft, wobei das ADC-Abtastraster bezüglich eines Referenzsignals ein initiales Referenzabtastraster mit mindestens einem initialen Referenz-Abtastpunkt des Referenzsignals definiert und die Referenzsignale der Referenzsignalreihe relativ zum ADC-Abtastraster mittels der ersten zeitlichen Verschiebung verschoben werden, sodass der mindestens eine initiale Referenz-Abtastpunkt mindestens einmal durch die erste ADC-Wandlungsstufe und mindestens einmal durch die zweite ADC-Wandlungsstufe erfasst wird; insbesondere wobei die Referenzsignale der Referenzsignalreihe relativ zum ADC-Abtastraster mittels der zweiten zeitlichen Verschiebung zusätzlich zeitlich verschoben werden, sodass in einem definierten Abtastbereich um den mindestens einen initialen Referenz-Abtastpunkt eine Vielzahl von sekundären jeweils um einen Bruchteil der Periodendauer des ADC-Taktes verschobenen Referenz-Abtastpunkten der Referenzsignale entstehen und dadurch unterschiedliche Signalpositionen um den mindestens einen initialen Referenz-Abtastpunkt mit variierendem Signalwert abgetastet werden.

Aufgrund dieser Referenzabtastung kann basierend auf den digitalisierten Referenzsignalen ein Referenz-Sendezeitpunkt für die Sendesignalreihe abgeleitet werden; basierend auf einem System-Clock ein System-Sendezeitpunkt für die Sendesignalreihe abgeleitet werden; und basierend auf dem Referenz-Sendezeitpunkt und dem System-Sendezeitpunkt eine Referenz-Zeitinformation für eine Bestimmung der ersten und/oder zweiten zeitlichen Verschiebung abgeleitet werden, welche bei einer Bestimmung eines Empfangszeitpunkts der Empfangssignalreihe und/oder der Bestimmung der Distanz zum Zielobjekt berücksichtigt wird.

In einer weiteren Ausführungsform ist das Laserdistanzmessmodul derart ausgebildet, dass die relativen zeitlichen Verschiebungen erzeugt werden mittels eines Verschiebens der Sendezeitpunkte der Sendesignale und/oder mittels eines Verschiebens der Abtastzeitpunkte der Empfangssignale.

Eine weitere Ausführungsform bezieht sich darauf, dass die Sendesignale basierend auf einem Sende-Clock ausgesendet werden und relativ zum Sende-Clock ein initialer relativer Aussendezeitpunkt eines Sendesignals definiert ist, und/oder die Empfangssignale basierend auf einem Empfangs-Clock erfasst werden und durch den Empfangs-Clock ein ADC-Clock für die Steuerung des ADC zur Erfassung einer Folge von Empfangssignalen definiert ist, wobei mittels eines ersten Phasenschiebers mindestens ein zum initialen relativen Aussendezeitpunkt zeitlich verschobener sekundärer relativer Aussendezeitpunkt des Sendesignals erzeugt wird, und/oder mittels eines zweiten Phasenschiebers der ADC-Clock relativ zum Empfangs-Clock zeitlich verschoben wird.

Die erfindungsgemässe Distanzmessmethode und das erfindungsgemässe Laserdistanzmessmodul werden nachfolgend anhand von in den Zeichnungen schematisch dargestellten Ausführungsbeispielen rein beispielhaft näher beschrieben. Gleiche Elemente sind in den Figuren mit gleichen Bezugszeichen gekennzeichnet. Die beschriebenen Ausführungsformen sind in der Regel nicht massstabsgetreu dargestellt und sie sind auch nicht als Einschränkung zu verstehen.

Im Einzelnen zeigen
- Fig. 1a,b:: schematische Illustration des Pulslaufzeitverfahrens in einem elektrooptischen Distanzmessgerät nach dem Stand der Technik;
- Fig. 2a,b:: Prinzipiendarstellung einer Digitalisierung durch einen Analog-Digital-Wandler (ADC) mit einem linearen Zusammenhang zwischen dem ADC-Eingangssignal und den digitalisierten Ausgangswerten (a) und mit einer Differentiellen Nichtlinearität (b);
- Fig. 3:: typische Fehlerkurve für eine Integrale Nichtlinearität eines schnellen ADC;
- Fig. 4a-c:: Illustration von Offset-, Timing- und Verstärkungseigenschaften/Fehlern von einzelnen ADC-Wandlungsstufen (z.B. ADC-Kernen);
- Fig. 5:: Illustration einer zeitlichen Verschiebung der Empfangssignalreihe gemäss einer Idee der vorliegenden Erfindung;
- Fig. 6a,b:: Illustration einer Mittelung über mehrere zeitlich verschobene Empfangssignale, mit zeitlichen Verschiebungen jeweils kleiner als das ADC-Taktintervalls (a) und zusätzlichen Verschiebungen um ganzzahlige Vielfache des ADC-Taktintervalls (b).

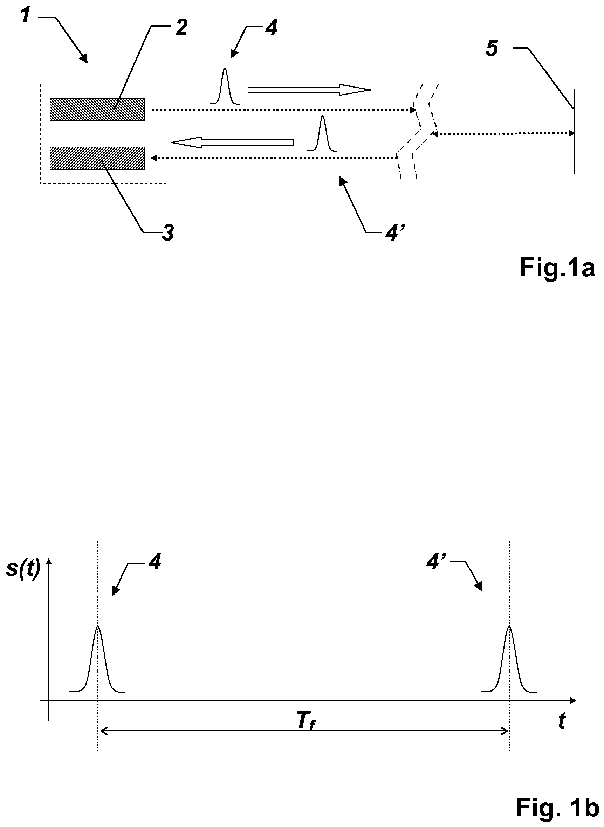

Die Figuren 1a und 1b illustrieren das Pulslaufzeitprinzip wie es in typischen elektro-optischen Distanzmessgeräten nach dem Stand der Technik verwendet wird.

**Figur 1a** zeigt eine Prinzipdarstellung eines elektrooptischen Distanzmessers 1 des Stands der Technik nach dem Pulslaufzeitprinzip. In dem Distanzmesser 1 sind ein Sender 2 und ein Empfänger 3 angeordnet. Der Sender 2 emittiert einen Lichtpuls 4, der nach der Reflektion bzw. Rückstreuung an einem Ziel, z.B. einem kooperativen Zielobjekt wie ein Retroreflektor 5 oder einem unkooperativen Zielobjekt wie eine natürliche Oberfläche, wieder als zurückgestreuter Lichtpuls 4' vom Empfänger 3 detektiert wird. Anstelle der Lichtpulse wird oft auch ein kontinuierlich moduliertes Sendesignal verwendet.

Wie in **Figur 1b** schematisch erläutert, wird die Entfernung aus der Laufzeit T_{f} als zeitliche Differenz zwischen dem Startzeitpunkt des Aussendens eines Lichtpulses 4 und dem Empfangszeitpunkt des zurückgestreuten Lichtpulses 4' ermittelt. Die Ermittlung des Empfangszeitpunktes erfolgt dabei durch die Auswertung eines Merkmals des Signalimpulses s(t), z.B. durch das Überschreiten einer Signalschwelle oder - wie in der vorliegenden Erfindung - durch Abtastung des Signalimpulses, wobei nach Identifikation der Codierung des zugehörigen Sendesignals eines empfangenen Signals aus einem definierten Verlaufspunkt des abgetasteten und digitalisierten Signals, beispielsweise den Wendepunkten, den Kurvenmaxima, oder integral mittels eines aus der Zeitinterpolation bekannten Optimum Filters, sehr genau eine Pulslaufzeit bestimmt wird. Eine weitere Methode für die Bestimmung eines definierten Verlaufspunkts umfasst z.B. auch eine Umwandlung des Empfangssignals in ein bipolares Signal und eine anschliessende Bestimmung des Nulldurchgangs.

Bei der zeitlich präzisen Abtastung des zurückgestreuten Pulses wird das vom Detektor erzeugte elektrische Signal mittels eines Analog-Digital-Wandlers ("Analog-Digital-Converter", ADC) in eine digitale Signalfolge umgewandelt, welches anschliessend meistens in Echtzeit weiter verarbeitet wird. Durch die Verwendung einer Vielzahl von Abtastfolgen und/oder zur Emissionsrate synchronem Aufsummieren des Empfangssignals kann ein Nutzsignal auch unter ungünstigen Umständen identifiziert werden, so dass auch grössere Distanzen oder verrauschte bzw. mit Störungen behaftete Hintergrundszenarien bewältigt werden können.

Bei schnellen Analog-Digital-Wandlern (ADC) wird die hohe Abtastrate in Verbindung mit einer hohen Auflösung der Signalwerte beispielsweise erreicht durch mehrere ADC-Wandlungsstufen, beispielweise durch ein zeitliches Verschachteln ("interleave", "interleaving") mehrerer langsamer ADCs oder ADC-Wandlungsstufen und/oder durch ein stufenweises Quantisieren ("pipeline", "pipelining"). Dabei entstehen trotz sorgfältiger interner Korrekturen architekturtypische Fehler, welche über Zeit und beispielsweise Temperatur variieren.

Bei interleaved ADCs entstehen die Fehler insbesondere dadurch, dass die verschiedenen ADC-Wandlungsstufen nicht exakt identische Eigenschaften in Bezug auf Offset, Verstärkung und Timing haben.

Bei pipelined-ADCs wirken sich die typischen Fehler meist als Differentielle Nichtlinearität DNL und Integrale Nichtlinearität INL aus. DNL und INL sind Fehler bei der Umwandlung der analogen Signalwerte in digitale (ganzzahlige) Werte, beispielsweise hervorgerufen durch das stufenweise Quantisieren bei einem pipelined-ADC in immer feiner werdende Schritte/immer grösser werdende Auflösung.

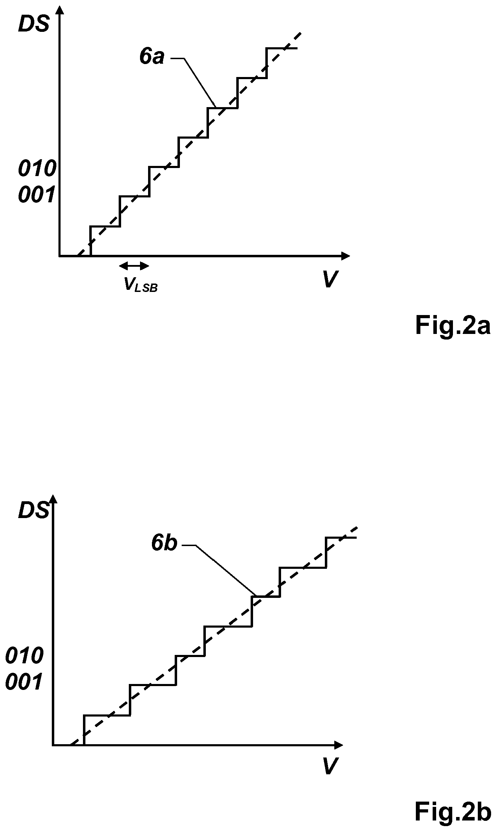

Die Figuren 2a und 2b illustrieren den Effekt einer Differentiellen Nichtlinearität DNL bei einer Digitalisierung durch einen Analog-Digital-Wandler (ADC). Die Figuren zeigen jeweils einen Plot für das erzeugte digitale Signal DS als Funktion der Spannung V eines analogen ADC-Eingangssignals.

**Figur 2a** illustriert den Idealfall, wobei die Digitalisierung derart erfolgt, dass die Differenz der Schwellspannung zum nächsten Digitalwert konstant ist, d.h. dass eine lineare Digitalisierung mit einer Digitalisierungs-Stufenfunktion 6a erzeugt wird, deren Stufenbreite V_{LSB} konstant ist. Jeweils zwei benachbarte digitale Werte, z.B. die digitalen Werte 001 und 010, entsprechen damit zwei umgesetzten analogen Eingangsspannungen, welche genau eine Sollspannung V_{LSB} ("Least Significant Bit") auseinander liegen.

Im Gegensatz dazu zeigt **Figur 2b** den Effekt einer Differentiellen Nichtlinearität DNL, wobei nun jeweils benachbarte digitale Werte, beispielsweise die digitalen Werte 001 und 010, analogen Eingansspannungen entsprechen, deren Spannungsdifferenz kleiner oder grösser als die Sollspannung V_{LSB} sind. Dies ergibt eine nichtlineare Digitalisierung mit einer Digitalisierungs-Stufenfunktion 6b mit unterschiedlicher Stufenbreite.

Der INL-Fehler ist im Wesentlichen die Summe aller DNL-Fehler aufsummiert bis zum Spannungswert V des Eingangssignals und kann mehrere LSB erreichen. Besonders der INL-Fehler hat deshalb bereits bei mässigen Schwankungen des Signalwerts gravierende Auswirkungen auf die digitalisierte Signalformgenauigkeit und bei der Distanzmessung entstehen durch den INL-Fehler über Distanz ein periodischer Distanzfehler im Abstand des Abtastrasters.

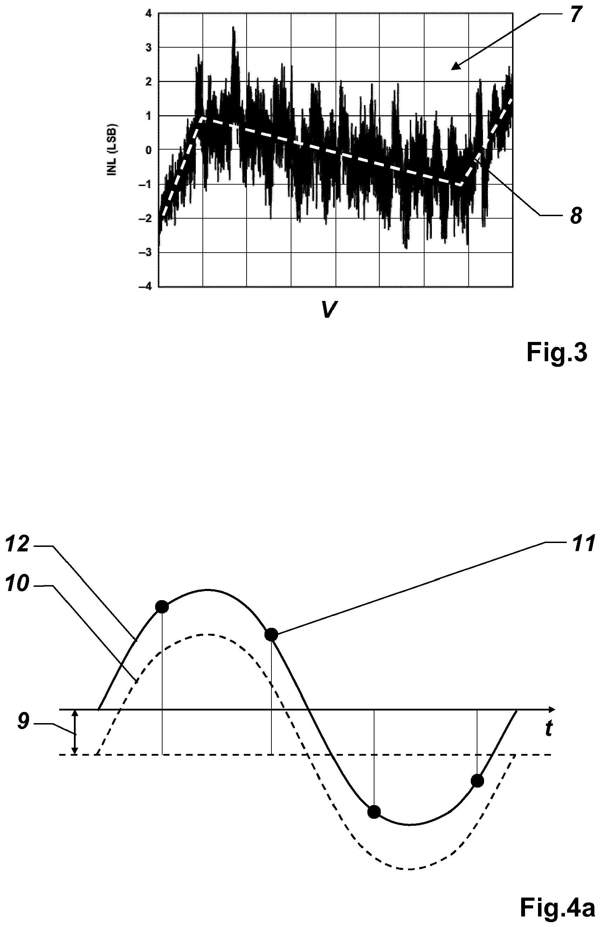

**Figur 3** zeigt eine typische Fehlerkurve 7 für eine Integrale Nichtlinearität INL, beispielweise einer schnellen Interleave-ADC Architektur oder eines Pipeline-ADC. Die INL-Fehlerkurve 7 zeigt als Funktion der ADC-Eingangsspannung V die Abweichung des digitalisierten Wertes vom idealen Sollwert ausgedrückt in LSB-Einheiten.

Der globale Verlauf der INL-Fehlerkurve 7 (typischerweise eine S-Form) ist hier der Einfachheit halber dargestellt durch eine Zickzack-Linie 8 mit drei unterschiedlichen Steigungen. Bleiben die abgetasteten Spannungswerte eines Empfangssignals innerhalb eines INL-Bereichs mit einem im Wesentlichen linearen Steigungswert, dann erzeugt dies eine amplitudenabhängige Signalverstärkung, was zu einer Verzerrung der Pulsform führt und die Distanzmessgenauigkeit reduziert. Umfasst die abgetastete Signalform grössere Abweichungen von einem mittleren, linearen Steigungsbereich der INL-Kurve (die Signalform umfasst z.B. einen "Knick" der Zickzack-Linie 8), dann entstehen weitere Verzerrungen an der Signalform und die Genauigkeit einer Distanzmessung zeigt zum Abtastraster zyklische Fehler.

Eine lokale Krümmung der INL-Fehlerkurve 7 (die lokalen Ausschläge/Abweichungen der INL-Fehlerkurve 7 vom globalen Verlauf 8) erzeugt einen Distanzmessfehler der beispielsweise zumindest einfach periodisch ist zum Abtastraster. Diese lokalen Ausschläge der INL-Kurve beeinflussen die Distanzmessgenauigkeit erheblich. Die lokale Krümmung der INL-Fehlerkurve und der dadurch entstehende Distanzmessfehler werden durch die Merkmale der vorliegenden Erfindung ebenfalls korrigiert.

Die Figuren 4a bis 4c illustrieren Offset-, Timing- und Verstärkungseigenschaften/Fehler von einzelnen ADC-Wandlungsstufen, beispielsweise von einzelnen ADC-Kernen bei interleaved ADCs, welche von ADC-Kern zu ADC-Kern leicht unterschiedlich sein können.

**Figur 4a** illustriert einen Offset-Fehler 9, oft auch Nullpunktfehler genannt, bei der Umwandlung eines ankommenden analogen Signals 10 in digitalisierte Werte 11, woraus wiederum ein Ausgangssignal 12 abgeleitet wird. Der Offset-Fehler 9 gibt an, wie gut eine aktuelle Digitalisierungs-Stufenfunktion 6a (siehe Fig. 2a) die ideale Transferfunktion an einem einzelnen Punkt wiedergibt. Bei einem idealen ADC findet die erste Umwandlung bei 0.5 LSB statt, wobei an das ankommende analoge Signal 10 eine Nullpunkt-Spannung angelegt wird. Je nach Einstellung der Nullpunktspannung, äusseren Einflüssen, beispielsweise der Temperatur, sowie internen Eigenschaften der Elektronik unterscheiden sich nun beispielsweise bei interleaved ADCs die Spannungslevel der internen Ausgänge der ADC-Wandlungsstufen.

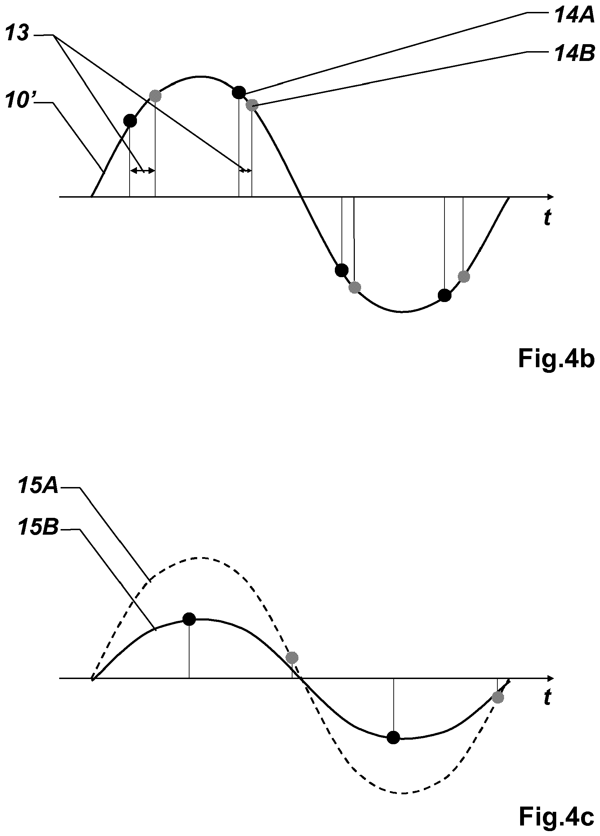

**Figur 4b** illustriert einen Timing-Fehler 13, auch Skew genannt, welcher dadurch entsteht, dass sich die relativen Sample-Intervalle der unterschiedlichen ADC-Wandlungsstufen oder ADCs für die Abtastung des analogen Signals 10' unterscheiden, wodurch das analoge Signal 10' mit einem ungleichmässigen Abtastraster abgetastet wird. Dadurch entstehen bei der Rekonstruktion des analogen Signals 10' aus den durch die unterschiedlichen ADC-Wandlungsstufen digitalisierten Werten 14A, 14B Verzerrungen an der Signalform.

**Figur 4c** illustriert einen Gain-Fehler, beispielsweise bei interleaved ADCs. Der Gain-Fehler eines ADCs oder einer ADC-Wandlungsstufe ist ein multiplikativer Fehler und beschreibt den proportionalen Zusammenhang zwischen ADC-Eingangsspannung und ADC-Ausgangssignal, d.h. wie gut die Steigung einer effektiven Digitalisierungs-Stufenfunktion 6a (siehe Fig. 2a) die ideale Transferfunktion wiedergibt. Typischerweise wird das ankommende Signal im ADC verstärkt oder gepuffert. Durch unterschiedliche Verstärkungsfaktoren der internen ADC-Kernbausteine wird die digitalisierte Signalform verzerrt, da die unterschiedlichen ADC-Kernbausteine unterschiedlich verstärkte Analogsignale 15A, 15B repräsentieren.

Gemäss der vorliegenden Erfindung werden durch zeitliche Verschiebungen der Empfangssignalreihe relativ zum ADC-Abtastraster um mindestens einen initialen Abtastpunkt eine Vielzahl von Abtastungen von unterschiedlichen Signalpositionen mit variierendem Signalwert erzeugt, insbesondere zeitliche Verschiebungen die kürzer sind als ein Taktintervall des ADC-Abtastrasters, und beispielsweise gemittelt, wobei unter anderem ein INL-Fehler und insbesondere bei interleaved ADCs z.B. Timing-Fehler sowie Gain- und Offset-Unterschiede der ADC-Wandlungsstufen gemittelt und reduziert werden.

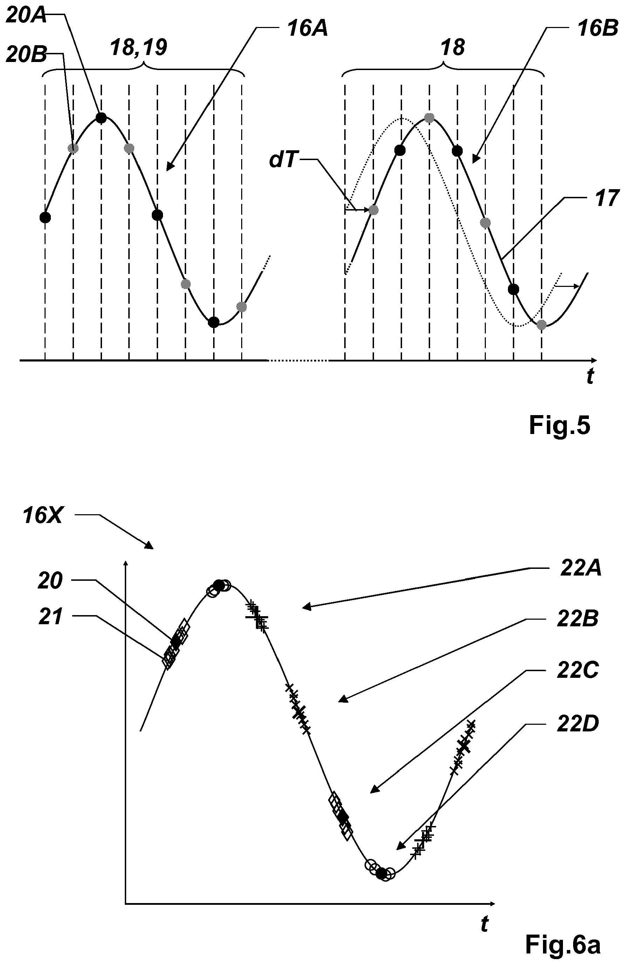

**Figur 5** illustriert eine erfindungsgemässe relative zeitliche Verschiebung eines Empfangssignals 16A der Empfangssignalreihe 17 bezüglich eines ADC-Abtastrasters 18 in ein zum hier fixen ADC-Abtastraster 18 zeitlich verschobenes Empfangssignal 16B, wobei hier das ADC-Abtastraster 18 durch einen ADC mit zwei Wandlungsstufen erzeugt wird. Dadurch wird, beispielsweise durch die Anordnung des ADC-Abtastrasters 18 bezüglich des Empfangssignals 16A zum Startzeitpunkt der Messung, ein initiales Signalabtastraster 19 mit initialen Abtastpunkten 20A,B, bezüglich des Empfangssignals 16A definiert, wobei hier die initialen Abtastpunkte abwechselnd einer ersten 20A und einer zweiten 20B ADC-Wandlungsstufe zugeordnet sind.

Durch die relative zeitliche Verschiebung dT, hier um genau einen Takt des ADC-Abtastrasters 18 ("erste" zeitliche Verschiebung), beispielsweise durch eine zeitliche Verschiebung der Sendezeitpunkte der Sendesignale, beispielsweise indem der Laser mit einer unterschiedlichen Frequenz oder asynchron zur ADC-Abtastung betrieben wird, werden die einzelnen Empfangssignale an den jeweiligen initialen Abtastpunkten 20A,B jeweils abwechselnd von der ersten und zweiten Wandlungsstufe abgetastet.

Zusätzlich kann beispielsweise eine ("scheinbare", siehe unten) relative zeitliche Verschiebung kleiner als das Taktintervall des ADC-Taktes 18 erzeugt werden ("zweite" zeitliche Verschiebung, nicht dargestellt), wodurch die einzelnen Empfangssignale innerhalb eines definierten zeitlichen Bereichs um die jeweiligen initialen Abtastpunkte 20A,B über das ADC-Abtastraster 18 "geschoben" werden. Hierdurch wird jeder Puls um die initialen Abtastpunkte 20A,B herum zusätzlich mit einer Vielzahl von jeweils um einen Bruchteil der Periodendauer des ADC-Taktes verschobenen sekundären Abtastungen abgetastet, wobei durch die sekundären Abtastpunkte unterschiedliche Signalpositionen um die initialen Abtastpunkte 20A,B mit variierender Amplitude (variierendem Signalwert) digitalisiert und beispielsweise gemittelt werden.

Fraktionale relative zeitliche Verschiebungen, die scheinbar kleiner sind als das Taktintervall (die Periodendauer) des ADC-Abtastrasters 18, können beispielsweise dadurch erzeugt werden, dass der zeitliche Abstand zwischen einzelnen Signalen einer Sendesignalfolge beispielsweise n+q Taktintervalle der Empfangseinheit beträgt, wobei n ganzzahlig und q < 1 ist. Die relative zeitliche Verschiebung des sekundär abgetasteten Empfangssignals ist dann kleiner als ein Taktintervall des initial abgetasteten Empfangssignals, auch wenn n beispielsweise 555 beträgt.

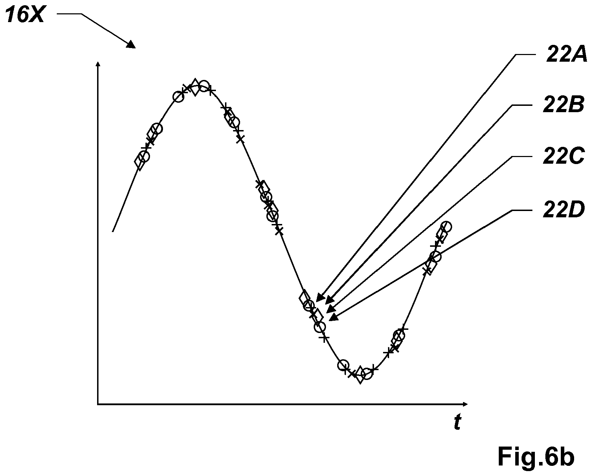

Falls die Architektur des ADC-Wandlers c Wandlungsstufen umfasst, dann ist es beispielsweise weiter vorteilhaft, wenn im Ausdruck n+q die Zahl n modulo c = r ungleich 0 ist. Trifft dies zu, dann ist die wirksame zeitliche Verschiebung r+q Taktintervalle und das Empfangssignal wird im ADC von Wandlungsstufe m zu Wandlungsstufe m+r verschoben. Eine optimale Einstellung liegt z.B. dann vor, falls (n modulo c) = 1 oder c-1 gilt. Zwei Beispiele sind beispielsweise in Fig. 6 beschrieben.

Durch das Überstreichen unterschiedlicher Amplituden (Signalwerte), d.h. verschiedener Fehlerzonen der ADC-Wandlungsstufe, wird beispielsweise durch eine Mittelung über eine Anzahl von Empfangssignalen der INL-Fehlereinfluss und der Einfluss von Timing-Fehlern sowie Gain- und Offset-Unterschiede auf eine Distanzmessung signifikant reduziert.

Eine alternative Lösung zur speziellen Kompensation des INL-Fehlerbeitrags, unter Berücksichtigung derselben Idee der Amplituden-Variation, ist beispielsweise in der von derselben Anmelderin gleichentags eingereichten Europäischen Anmeldung "Laserdistanzmessmodul mit INL-Fehlerkompensation" (Anmeldenummer EP16205847.3)beschrieben.

**Figur 6a** illustriert eine Mittelung über mehrere identische Empfangssignale 16X ("Einzelschüsse") einer Empfangssignalreihe, hier zum Beispiel verarbeitet mittels vier unterschiedlichen ADC-Wandlungsstufen, beispielsweise vier unterschiedliche ADC-Wandlungsstufen 22A,22B,22C,22D in einer interleaved Architektur.

Gemäss der vorliegenden Erfindung werden die Einzelschüsse beispielsweise derart ausgesendet, dass die Empfangssignale zu den initialen Abtastpunkten 20 jeweils mit einer Vielzahl von um die initialen Abtastpunkte 20 angeordneten zusätzlichen sekundären Abtastpunkten 21 innerhalb eines definierten Abtastbereichs abgetastet werden, wobei sich die sekundären Abtastpunkte 21 jeweils bloss um einen Bruchteil des ADC-Taktintervalls vom zugehörigen initialen Abtastpunkt unterscheiden (oben "zweite" zeitliche Verschiebung genannt). Dies ist z.B. der Fall, wenn der zeitliche Abstand n+q (siehe Beschreibung oben zu Fig. 5) zwischen einzelnen Signalen der Sendesignalfolge im Vergleich zu den hier c=4 Wandlungsstufen des ADC-Wandlers die Relation n modulo c = 0 erfüllt, was also bedeutet, dass die sekundären Abtastpunkte über mehrere, genauer 1/q Sendesignalfolgen von derselben zugeordneten Wandlungsstufe abgetastet werden. Nach einer ausreichenden Anzahl von empfangenen Sendesignalen entsteht dabei eine ausreichende Fehlerauslöschung, insbesondere wenn die Subsamples jedes initialen Abtastpunkts einen definierten Wertebereich der Empfangssignale 16X durchlaufen haben.

Wie in **Figur 6b** dargestellt ist es zudem vorteilhaft, insbesondere um beispielsweise für eine vorgegebene Fehlerauslöschung die Anzahl der für eine Mittelung benötigten Signalpulse und daher die Messzeiten signifikant zu verkürzen, die einzelnen Signalpulse 16X jeweils zusätzlich zur kontinuierlichen Verschiebung (oben "zweite" zeitliche Verschiebung,< Taktintervall) um ein ganzzahliges Vielfaches des Taktintervalls von Wandlungsstufe zu Wandlungsstufe des ADC zu schieben (oben "erste" zeitliche Verschiebung genannt).

Eine effektive zeitliche Verschiebung wird beispielsweise erreicht, falls im Ausdruck n+q die Zahl n modulo c = r ungleich 0 ist. Eine optimale Einstellung für die Sendesignalperiode liegt beispielsweise bei n modulo c = 1 oder = c-1 vor, was bedeutet, dass korrespondierende sekundäre Abtastpunkte von Wandlungsstufe zu Wandlungsstufe geschoben und abgetastet werden. Dadurch vermischen sich die den ADC-Wandlungsstufen zugeordneten Subsamples 22A,22B,22C,22D bereits nach wenigen Signalpulsen und eine ausreichende Fehlerauslöschung ist bereits nach kurzen Messzeiten gewährleistet.

Es versteht sich, dass diese dargestellten Figuren nur mögliche Ausführungsbeispiele schematisch darstellen. Die verschiedenen Ansätze können ebenso miteinander sowie mit Verfahren des Stands der Technik kombiniert werden.

## Patentansprüche

1. Distanzmessmethode, insbesondere für ein Laser-Distanzmessgerät, im Speziellen ausgebildet als Lasertracker, Tachymeter, Laserscanner, oder Profiler, zur Bestimmung einer Distanz zu einem Zielobjekt mit
• einem Aussenden von Sendesignalen, insbesondere gepulsten Sendesignalen, als Sendesignalreihe,
• einem Empfangen von zumindest Teilen der am Zielobjekt reflektierten Sendesignale der Sendesignalreihe als Empfangssignale (16A,16B) einer Empfangssignalreihe (17),
• einem Digitalisieren der Empfangssignale der Empfangssignalreihe in Digitalsignale (11,14A,14B) einer Digitalsignalreihe mittels eines Analog-Digital-Wandlers, nachfolgend ADC genannt, insbesondere vom Typ Interleaved-ADC oder Pipelined-ADC, mit einem durch mindestens zwei ADC-Wandlungsstufen (22A,22B,22C,22D) erzeugten ADC-Abtastraster (18), und
• einem Verarbeiten der Digitalsignalreihe um daraus die Distanz zum Zielobjekt abzuleiten, insbesondere wobei die Bestimmung der Distanz auf dem Pulslaufzeitverfahren basiert,
**dadurch gekennzeichnet, dass**
• das ADC-Abtastraster (18) bezüglich eines Empfangssignals ein initiales Signalabtastraster (19) mit mindestens einem initialen Abtastpunkt (20,20A,20B) des Empfangssignals definiert, und
• die Empfangssignale der Empfangssignalreihe (17) relativ zum ADC-Abtastraster (18) mittels einer ersten zeitlichen Verschiebung derart zeitlich verschoben werden, dass der mindestens eine initiale Abtastpunkt (20,20A,20B) mindestens einmal durch eine erste ADC-Wandlungsstufe (22A,22B,22C,22D) und mindestens einmal durch eine zweite ADC-Wandlungsstufe (22A,22B,22C,22D) erfasst wird, insbesondere wobei die Empfangssignale der Empfangssignalreihe (17) relativ zum ADC-Abtastraster (18) mittels einer zweiten zeitlichen Verschiebung zusätzlich zeitlich verschoben werden, dass in einem definierten Abtastbereich um den mindestens einen initialen Abtastpunkt (20,20A,20B) eine Vielzahl von sekundären jeweils um einen Bruchteil der Periodendauer des ADC-Taktes verschobenen Abtastpunkten (21) der Empfangssignale entstehen und dadurch unterschiedliche Signalpositionen um den mindestens einen initialen Abtastpunkt (20,20A,20B) mit variierendem Signalwert abgetastet werden.

2. Distanzmessmethode nach Anspruch 1,
**dadurch gekennzeichnet, dass**
die Sendesignale basierend auf einem Sende-Clock ausgesendet werden und die Empfangssignale basierend auf einem ADC-Clock erfasst werden, wobei im Rahmen eines Messvorgangs mindestens eine der folgenden Bedingungen erfüllt ist:
• der Sende-Clock ist asynchron zum ADC-Clock,
• die Periodendauer des Sende-Clocks und/oder eine Periodendauer der Sendesignale ist unterschiedlich zur Periodendauer des ADC-Taktes oder zu einem ganzzahligen Vielfachen der Periodendauer des ADC-Taktes, und
• die der Sende-Clockfrequenz und/oder einer Wiederholrate der Sendesignale entsprechende Sende-Periode Tₛ ist gegeben als Tₛ = (n + q) * T_{ADC}, wobei n eine ganze Zahl ist, q eine gebrochene Zahl mit Betrag < 1 und T_{ADC} die Periodendauer des ADC-Taktes, wobei für eine Anzahl verwendeter ADC-Wandlungsstufen c die Bedingung n modulo c ≠ 0 erfüllt ist.

3. Distanzmessmethode nach einem der vorhergehenden Ansprüche,
**dadurch gekennzeichnet, dass**
die Empfangssignale der Empfangssignalreihe (17) relativ zum ADC-Abtastraster (18) mit einer definierten Anzahl erster zeitlicher Verschiebungen verschoben werden, wobei die Anzahl erster zeitlicher Verschiebungen eingestellt wird basierend auf mindestens einem Element der folgenden Gruppe:
• einer definierten minimalen Anzahl Abtastungen des mindestens einen initialen Abtastpunkts durch jede der verwendeten ADC-Wandlungsstufen (22A,22B,22C,22D),
• einer definierten Messgenauigkeit für die Bestimmung der Distanz,
• einem gemessenen Signalwert des Empfangssignals, und
• einer vorgegebenen Messzeit.

4. Distanzmessmethode nach einem der vorhergehenden Ansprüche,
**dadurch gekennzeichnet, dass**
die Empfangssignale der Empfangssignalreihe (17) relativ zum ADC-Abtastraster (18) mit einer definierten Anzahl zweiter zeitlicher Verschiebungen verschoben werden, wodurch der Abtastbereich mit einer definierten Anzahl sekundärer Abtastpunkte (21) abgetastet wird, wobei die Anzahl sekundärer Abtastpunkte eingestellt wird basierend auf mindestens einem Element der folgenden Gruppe:
• einer definierten minimalen Anzahl von zueinander unterschiedlicher sekundärer Abtastpunkte, insbesondere basierend auf einer minimalen Anzahl Abtastungen jedes sekundären Abtastpunkts durch jede der verwendeten ADC-Wandlungsstufen (22A,22B,22C,22D),
• einer definierten Messgenauigkeit für die Bestimmung der Distanz,
• einem gemessenen Signalwert des Empfangssignals, und
• einer vorgegebenen Messzeit.

5. Distanzmessmethode nach einem der vorhergehenden Ansprüche,
**dadurch gekennzeichnet, dass**
zumindest Teile der Sendesignale als Referenzsignale einer Referenzsignalreihe (17) über eine Referenzstrecke mit bekannter, unveränderlicher Länge verlaufen und mittels des ADC digitalisiert werden, insbesondere mittels Reflektion am Zielobjekt in einem bekannten, unveränderlichen Abstand oder ohne vorherige Reflektion am Zielobjekt, im Speziellen wobei die Referenzstrecke komplett innerhalb des Laser-Distanzmessgeräts verläuft, wobei
• das ADC-Abtastraster (18) bezüglich eines Referenzsignals ein initiales Referenzabtastraster (19) mit mindestens einem initialen Referenz-Abtastpunkt (20,20A,20B) des Referenzsignals definiert, und
• die Referenzsignale der Referenzsignalreihe (17) relativ zum ADC-Abtastraster (18) mittels der ersten zeitlichen Verschiebung verschoben werden, sodass der mindestens eine initiale Referenz-Abtastpunkt mindestens einmal durch die erste ADC-Wandlungsstufe (22A,22B,22C,22D) und mindestens einmal durch die zweite ADC-Wandlungsstufe (22A,22B,22C,22D) erfasst wird,
insbesondere wobei die Referenzsignale der Referenzsignalreihe (17) relativ zum ADC-Abtastraster (18) mittels der zweiten zeitlichen Verschiebung zusätzlich zeitlich verschoben werden, dass in einem definierten Abtastbereich um den mindestens einen initialen Referenz-Abtastpunkt (20,20A,20B) eine Vielzahl von sekundären jeweils um einen Bruchteil der Periodendauer des ADC-Taktes verschobenen Referenz-Abtastpunkten (21) der Referenzsignale entstehen und dadurch unterschiedliche Signalpositionen um den mindestens einen initialen Referenz-Abtastpunkt mit variierendem Signalwert abgetastet werden,
wobei
• basierend auf den digitalisierten Referenzsignalen ein Referenz-Sendezeitpunkt für die Sendesignalreihe abgeleitet wird,
• basierend auf einem System-Clock ein System-Sendezeitpunkt für die Sendesignalreihe abgeleitet wird, und
• basierend auf dem Referenz-Sendezeitpunkt und dem System-Sendezeitpunkt eine Referenz-Zeitinformation für eine Bestimmung der ersten und/oder zweiten zeitlichen Verschiebung abgeleitet wird, welche bei einer Bestimmung eines Empfangszeitpunkts der Empfangssignalreihe und/oder der Bestimmung der Distanz zum Zielobjekt berücksichtigt wird.

6. Distanzmessmethode nach einem der vorhergehenden Ansprüche,
**dadurch gekennzeichnet, dass**
die relativen zeitlichen Verschiebungen erzeugt werden
• mittels eines Verschiebens der Sendezeitpunkte der Sendesignale, und/oder
• mittels eines Verschiebens der Abtastzeitpunkte der Empfangssignale.

7. Distanzmessmethode nach einem der vorhergehenden Ansprüche,
**dadurch gekennzeichnet, dass**
• die Sendesignale basierend auf einem Sende-Clock ausgesendet werden und relativ zum Sende-Clock ein initialer relativer Aussendezeitpunkt eines Sendesignals definiert ist, und/oder
• die Empfangssignale basierend auf einem Empfangs-Clock erfasst werden und durch den Empfangs-Clock ein ADC-Clock für die Steuerung des ADC zur Erfassung einer Folge von Empfangssignalen definiert ist,
wobei
• mittels eines ersten Phasenschiebers mindestens ein zum initialen relativen Aussendezeitpunkt zeitlich verschobener sekundärer relativer Aussendezeitpunkt des Sendesignals erzeugt wird, und/oder
• mittels eines zweiten Phasenschiebers der ADC-Clock relativ zum Empfangs-Clock zeitlich verschoben wird.

8. Elektronisches Laserdistanzmessmodul, insbesondere zur Verwendung in einem Distanzmessgerät, im Speziellen ausgebildet als Lasertracker, Tachymeter, Laserscanner, oder Profiler, für eine Bestimmung einer Distanz zu einem Zielobjekt mit
• einem optischen Sendekanal mit einer Sendeeinheit zur Erzeugung von Sendesignalen einer Sendesignalreihe, insbesondere mittels gepulster Lasermessstrahlung,
• einem optischen Empfangskanal mit einer Empfangseinheit zum Empfang von zumindest Teilen der am Zielobjekt reflektierten Sendesignale der Sendesignalreihe als Empfangssignale (16A,16B) einer Empfangssignalreihe (17),
• einer Empfangsschaltung für eine Digitalisierung der Empfangssignale der Empfangssignalreihe in Digitalsignale (11,14A,14B) einer Digitalsignalreihe mit einem Analog-Digital-Wandlers, nachfolgend ADC genannt, insbesondere vom Typ Interleaved-ADC oder Pipelined-ADC, mit einem durch mindestens zwei ADC-Wandlungsstufen (22A,22B,22C,22D) erzeugten ADC-Abtastraster (18), und
• einer Kontroll- und Steuereinheit für eine Bestimmung der Distanz zum Zielobjekt basierend auf einer Verarbeitung der Digitalsignalreihe, insbesondere wobei die Bestimmung der Distanz auf dem Pulslaufzeitverfahren basiert,
**dadurch gekennzeichnet, dass**
das Laserdistanzmessmodul derart ausgebildet ist, dass
• das ADC-Abtastraster (18) bezüglich eines Empfangssignals ein initiales Signalabtastraster (19) mit mindestens einem initialen Abtastpunkt (20,20A,20B) des Empfangssignals definiert, und
• die Empfangssignale der Empfangssignalreihe (17) relativ zum ADC-Abtastraster (18) mittels einer ersten zeitlichen Verschiebung derart zeitlich verschoben werden, dass der mindestens eine initiale Abtastpunkt (20,20A,20B) mindestens einmal durch eine erste ADC-Wandlungsstufe (22A,22B,22C,22D) und mindestens einmal durch eine zweite ADC-Wandlungsstufe (22A,22B,22C,22D) erfasst wird,
insbesondere wobei die Empfangssignale der Empfangssignalreihe (17) relativ zum ADC-Abtastraster (18) mittels einer zweiten zeitlichen Verschiebung zusätzlich zeitlich verschoben werden, dass in einem definierten Abtastbereich um den mindestens einen initialen Abtastpunkt (20,20A,20B) eine Vielzahl von sekundären jeweils um einen Bruchteil der Periodendauer des ADC-Taktes verschobenen Abtastpunkten (21) der Empfangssignale entstehen und dadurch unterschiedliche Signalpositionen um den mindestens einen initialen Abtastpunkt (20,20A,20B) mit variierendem Signalwert abgetastet werden.

9. Laserdistanzmessmodul nach Anspruch 8,
**dadurch gekennzeichnet, dass**
das Laserdistanzmessmodul derart ausgebildet ist, dass die Sendesignale basierend auf einem Sende-Clock ausgesendet werden und die Empfangssignale basierend auf einem ADC-Clock erfasst werden, wobei im Rahmen eines Messvorgangs mindestens eine der folgenden Bedingungen erfüllt ist:
• der Sende-Clock ist asynchron zum ADC-Clock,
• die Periodendauer des Sende-Clocks und/oder eine Periodendauer der Sendesignale ist unterschiedlich zur Periodendauer des ADC-Taktes oder einem ganzzahligen Vielfachen der Periodendauer des ADC-Taktes, und
• die der Sende-Clockfrequenz und/oder einer Wiederholrate der Sendesignale entsprechende Sende-Periode Tₛ ist gegeben als Tₛ = (n + q) * T_{ADC}, wobei n eine ganze Zahl ist, q eine gebrochene Zahl zwischen -1 und +1 und T_{ADC} die Periodendauer des ADC-Taktes, wobei für eine Anzahl verwendeter ADC-Wandlungsstufen c die Bedingung n modulo c ≠ 0 erfüllt ist.

10. Laserdistanzmessmodul nach Anspruch 8 oder 9,
**dadurch gekennzeichnet, dass**
das Laserdistanzmessmodul derart ausgebildet ist, dass die Empfangssignale der Empfangssignalreihe (17) relativ zum ADC-Abtastraster (18) mit einer definierten Anzahl erster zeitlicher Verschiebungen verschoben werden, wobei die Anzahl erster zeitlicher Verschiebungen eingestellt wird basierend auf mindestens einem Element der folgenden Gruppe:
• einer definierten minimalen Anzahl Abtastungen des mindestens einen initialen Abtastpunkts durch jede der verwendeten ADC-Wandlungsstufen (22A,22B,22C,22D),
• einer definierten Messgenauigkeit für die Bestimmung der Distanz,
• einem gemessenen Signalwert des Empfangssignals, und
• einer vorgegebenen Messzeit.

11. Laserdistanzmessmodul nach einem der Ansprüche 8 bis 10,
**dadurch gekennzeichnet, dass**
das Laserdistanzmessmodul derart ausgebildet ist, dass die Empfangssignale der Empfangssignalreihe (17) relativ zum ADC-Abtastraster (18) mit einer definierten Anzahl zweiter zeitlicher Verschiebungen verschoben werden, wodurch der Abtastbereich mit einer definierten Anzahl sekundärer Abtastpunkte (21) abgetastet wird, wobei die Anzahl sekundärer Abtastpunkte eingestellt wird basierend auf mindestens einem Element der folgenden Gruppe:
• einer definierten minimalen Anzahl von zueinander unterschiedlicher sekundärer Abtastpunkte, insbesondere basierend auf einer minimalen Anzahl Abtastungen jedes sekundären Abtastpunkts durch jede der verwendeten ADC-Wandlungsstufen (22A,22B,22C,22D),
• einer definierten Messgenauigkeit für die Bestimmung der Distanz,
• einem gemessenen Signalwert des Empfangssignals, und
• einer vorgegebenen Messzeit.

12. Laserdistanzmessmodul nach einem der Ansprüche 8 bis 11,
**dadurch gekennzeichnet, dass**
das Laserdistanzmessmodul derart ausgebildet ist, dass zumindest Teile der Sendesignale als Referenzsignale einer Referenzsignalreihe (17) über eine Referenzstrecke mit bekannter, unveränderlicher Länge verlaufen und mittels des ADC digitalisiert werden, insbesondere mittels Reflektion am Zielobjekt in einem bekannten, unveränderlichen Abstand oder ohne vorherige Reflektion am Zielobjekt, im Speziellen wobei die Referenzstrecke komplett innerhalb des Laser-Distanzmessgeräts verläuft, wobei
• das ADC-Abtastraster (18) bezüglich eines Referenzsignals ein initiales Referenzabtastraster (19) mit mindestens einem initialen Referenz-Abtastpunkt (20,20A,20B) des Referenzsignals definiert, und
• die Referenzsignale der Referenzsignalreihe (17) relativ zum ADC-Abtastraster (18) mittels der ersten zeitlichen Verschiebung verschoben werden, sodass der mindestens eine initiale Referenz-Abtastpunkt (20,20A,20B) mindestens einmal durch die erste ADC-Wandlungsstufe (22A,22B,22C,22D) und mindestens einmal durch die zweite ADC-Wandlungsstufe (22A,22B,22C,22D) erfasst wird,
insbesondere wobei die Referenzsignale der Referenzsignalreihe (17) relativ zum ADC-Abtastraster (18) mittels der zweiten zeitlichen Verschiebung zusätzlich zeitlich verschoben werden, dass in einem definierten Abtastbereich um den mindestens einen initialen Referenz-Abtastpunkt (20,20A,20B) eine Vielzahl von sekundären jeweils um einen Bruchteil der Periodendauer des ADC-Taktes verschobenen Referenz-Abtastpunkten (21) der Referenzsignale entstehen und dadurch unterschiedliche Signalpositionen um den mindestens einen initialen Referenz-Abtastpunkt mit variierendem Signalwert abgetastet werden,
wobei
• basierend auf den digitalisierten Referenzsignalen ein Referenz-Sendezeitpunkt für die Sendesignalreihe abgeleitet wird,
• basierend auf einer System-Clock ein System-Sendezeitpunkt für die Sendesignalreihe abgeleitet wird, und
• basierend auf dem Referenz-Sendezeitpunkt und dem System-Sendezeitpunkt eine Referenz-Zeitinformation für eine Bestimmung der ersten und/oder zweiten zeitlichen Verschiebung abgeleitet wird, welche bei einer Bestimmung eines Empfangszeitpunkts der Empfangssignalreihe und/oder der Bestimmung der Distanz zum Zielobjekt berücksichtigt wird.

13. Laserdistanzmessmodul nach einem der Ansprüche 8 bis 12,
**dadurch gekennzeichnet, dass**
die relativen zeitlichen Verschiebungen erzeugt werden
• mittels eines Verschiebens der Sendezeitpunkte der Sendesignale, und/oder
• mittels eines Verschiebens der Abtastzeitpunkte der Empfangssignale.

14. Laserdistanzmessmodul nach einem der Ansprüche 8 bis 13,
**dadurch gekennzeichnet, dass**
• die Sendesignale basierend auf einem Sende-Clock ausgesendet werden und relativ zum Sende-Clock ein initialer relativer Aussendezeitpunkt eines Sendesignals definiert ist, und/oder
• die Empfangssignale basierend auf einem Empfangs-Clock erfasst werden und durch den Empfangs-Clock ein ADC-Clock für die Steuerung des ADC zur Erfassung einer Folge von Empfangssignalen definiert ist,
wobei
• mittels eines ersten Phasenschiebers mindestens ein zum initialen relativen Aussendezeitpunkt zeitlich verschobener sekundärer relativer Aussendezeitpunkt des Sendesignals erzeugt wird, und/oder
• mittels eines zweiten Phasenschiebers der ADC-Clock relativ zum Empfangs-Clock zeitlich verschoben wird.

## Claims

1. A distance measuring method, in particular for a laser distance measuring apparatus, especially configured as a laser tracker, tachymeter, laser scanner, or profiler, for determining a distance to a target object comprising
• emitting transmission signals, in particular pulsed transmission signals, as a transmission signal series,
• receiving at least portions of the transmission signals of the transmission signal series reflected at the target object as reception signals (16A, 16B) of a reception signal series (17),
• digitizing the reception signals of the reception signal series into digital signals (11, 14A, 14B) of a digital signal series by means of an analog-to-digital converter, referred to hereinafter as ADC, in particular of the interleaved ADC or pipelined ADC type, with an ADC sampling pattern (18) generated by at least two ADC conversion stages (22A, 22B, 22C, 22D), and
• processing the digital signal series in order to derive the distance to the target object therefrom,
in particular wherein the determination of the distance is based on the pulse time-of-flight method,
**wherein**
• the ADC sampling pattern (18) defines with respect to a reception signal an initial signal sampling pattern (19) with at least one initial sampling point (20, 20A, 20B) of the reception signal, and
• the reception signals of the reception signal series (17) are temporally shifted relative to the ADC sampling pattern (18) by means of a first temporal shift in such a way that the at least one initial sampling point (20, 20A, 20B) is detected at least once by a first ADC conversion stage (22A, 22B, 22C, 22D) and at least once by a second ADC conversion stage (22A, 22B, 22C, 22D),
in particular wherein the reception signals of the reception signal series (17) are additionally temporally shifted relative to the ADC sampling pattern (18) by means of a second temporal shift such that in a defined sampling range around the at least one initial sampling point (20, 20A, 20B) a multiplicity of secondary sampling points (21) of the reception signals arise, said secondary sampling points being shifted in each case by a fraction of the period duration of the ADC clock signal, and this results in the sampling of different signal positions around the at least one initial sampling point (20, 20A, 20B) with a varying signal value.

2. The distance measuring method as claimed in claim 1,
**wherein**
the transmission signals are emitted on the basis of a transmission clock and the reception signals are detected on the basis of an ADC clock, wherein at least one of the following conditions is met in the context of a measuring process:
• the transmission clock is asynchronous with respect to the ADC clock,
• the period duration of the transmission clock and/or a period duration of the transmission signals are/is different than the period duration of the ADC clock signal or than an integral multiple of the period duration of the ADC clock signal, and
• the transmission period Tₛ corresponding to the transmission clock frequency and/or to a repetition rate of the transmission signals is given as Tₛ = (n + q) * T_{ADC}, wherein n is an integer, q is a fractional number having an absolute value of < 1, and T_{ADC} is the period duration of the ADC clock signal, wherein for a number of ADC conversion stages c used the condition n modulo c ≠ 0 is met.

3. The distance measuring method as claimed in any one of the preceding claims,
**wherein**
the reception signals of the reception signal series (17) are shifted relative to the ADC sampling pattern (18) with a defined number of first temporal shifts, wherein the number of first temporal shifts is set on the basis of at least one element of the following group:
• a defined minimum number of samplings of the at least one initial sampling point by each of the ADC conversion stages (22A, 22B, 22C, 22D) used,
• a defined measurement accuracy for the determination of the distance,
• a measured signal value of the reception signal, and
• a predefined measurement time.

4. The distance measuring method as claimed in any one of the preceding claims,
**wherein**
the reception signals of the reception signal series (17) are shifted relative to the ADC sampling pattern (18) with a defined number of second temporal shifts, as a result of which the sampling range is sampled with a defined number of secondary sampling points (21), wherein the number of secondary sampling points is set on the basis of at least one element of the following group:
• a defined minimum number of mutually different secondary sampling points, in particular on the basis of a minimum number of samplings of each secondary sampling point by each of the ADC conversion stages (22A, 22B, 22C, 22D) used,
• a defined measurement accuracy for the determination of the distance,
• a measured signal value of the reception signal, and
• a predefined measurement time.

5. The distance measuring method as claimed in any one of the preceding claims,
**wherein**
at least portions of the transmission signals as reference signals of a reference signal series (17) pass via a reference section having a known, invariable length and are digitized by means of the ADC, in particular by means of reflection at the target object at a known, invariable distance or without prior reflection at the target object, especially wherein the reference section extends completely within the laser distance measuring apparatus, wherein
• the ADC sampling pattern (18) defines with respect to a reference signal an initial reference sampling pattern (19) with at least one initial reference sampling point (20, 20A, 20B) of the reference signal, and
• the reference signals of the reference signal series (17) are shifted relative to the ADC sampling pattern (18) by means of the first temporal shift, such that the at least one initial reference sampling point is detected at least once by the first ADC conversion stage (22A, 22B, 22C, 22D) and at least once by the second ADC conversion stage (22A, 22B, 22C, 22D),
in particular wherein the reference signals of the reference signal series (17) are additionally temporally shifted relative to the ADC sampling pattern (18) by means of the second temporal shift such that in a defined sampling range around the at least one initial reference sampling point (20, 20A, 20B) a multiplicity of secondary reference sampling points (21) of the reference signals arise, said secondary reference sampling points being shifted in each case by a fraction of the period duration of the ADC clock signal, and this results in the sampling of different signal positions around the at least one initial reference sampling point with a varying signal value,
wherein
• a reference transmission instant for the transmission signal series is derived on the basis of the digitized reference signals,
• a system transmission instant for the transmission signal series is derived on the basis of a system clock, and
• on the basis of the reference transmission instant and the system transmission instant reference time information for a determination of the first and/or second temporal shift is derived, which is taken into account during a determination of a reception instant of the reception signal series and/or the determination of the distance to the target object.

6. The distance measuring method as claimed in any one of the preceding claims,
**wherein**
the relative temporal shifts are generated
• by means of shifting the transmission instants of the transmission signals, and/or
• by means of shifting the sampling instants of the reception signals.

7. The distance measuring method as claimed in any one of the preceding claims,
**wherein**
• the transmission signals are emitted on the basis of a transmission clock and an initial relative emission instant of a transmission signal is defined relative to the transmission clock, and/or
• the reception signals are detected on the basis of a reception clock and an ADC clock for the control of the ADC for detecting a sequence of reception signals is defined by the reception clock,
wherein
• at least one secondary relative emission instant of the transmission signal that is temporally shifted with respect to the initial relative emission instant is generated by means of a first phase shifter, and/or
• the ADC clock is temporally shifted relative to the reception clock by means of a second phase shifter.

8. An electronic laser distance measuring module, in particular for use in a distance measuring apparatus, especially configured as a laser tracker, tachymeter, laser scanner, or profiler, for determining a distance to a target object comprising
• an optical transmission channel having a transmitting unit for generating transmission signals of a transmission signal series, in particular by means of pulsed laser measurement radiation,
• an optical reception channel having a receiving unit for receiving at least portions of the transmission signals of the transmission signal series reflected at the target object as reception signals (16A, 16B) of a reception signal series (17),
• a reception circuit for digitizing the reception signals of the reception signal series into digital signals (11, 14A, 14B) of a digital signal series with an analog-to-digital converter, referred to as ADC hereinafter, in particular of the interleaved ADC or pipelined ADC type, with an ADC sampling pattern (18) generated by at least two ADC conversion stages (22A, 22B, 22C, 22D), and
• a supervisory and control unit for determining the distance to the target object on the basis of a processing of the digital signal series, in particular wherein the determination of the distance is based on the pulse time-of-flight method,
**wherein**
the laser distance measuring module is configured in such a way that
• the ADC sampling pattern (18) defines with respect to a reception signal an initial signal sampling pattern (19) with at least one initial sampling point (20, 20A, 20B) of the reception signal, and
• the reception signals of the reception signal series (17) are temporally shifted relative to the ADC sampling pattern (18) by means of a first temporal shift in such a way that the at least one initial sampling point (20, 20A, 20B) is detected at least once by a first ADC conversion stage (22A, 22B, 22C, 22D) and at least once by a second ADC conversion stage (22A, 22B, 22C, 22D),
in particular wherein the reception signals of the reception signal series (17) are additionally temporally shifted relative to the ADC sampling pattern (18) by means of a second temporal shift such that in a defined sampling range around the at least one initial sampling point (20, 20A, 20B) a multiplicity of secondary sampling points (21) of the reception signals arise, said secondary sampling points being shifted in each case by a fraction of the period duration of the ADC clock signal, and this results in the sampling of different signal positions around the at least one initial sampling point (20, 20A, 20B) with a varying signal value.

9. The laser distance measuring module as claimed in claim 8,
**wherein**
the laser distance measuring module is configured in such a way that the transmission signals are emitted on the basis of a transmission clock and the reception signals are detected on the basis of an ADC clock, wherein at least one of the following conditions is met in the context of a measuring process:
• the transmission clock is asynchronous with respect to the ADC clock,
• the period duration of the transmission clock and/or a period duration of the transmission signals are/is different than the period duration of the ADC clock signal or than an integral multiple of the period duration of the ADC clock signal, and
• the transmission period Tₛ corresponding to the transmission clock frequency and/or to a repetition rate of the transmission signals is given as Tₛ = (n + q) * T_{ADC}, wherein n is an integer, q is a fractional number having an absolute value of between -1 and +1, and T_{ADC} is the period duration of the ADC clock signal, wherein for a number of ADC conversion stages c used the condition n modulo c ≠ 0 is met.

10. The laser distance measuring module as claimed in claim 8 or 9,
**wherein**
the laser distance measuring module is configured in such a way that the reception signals of the reception signal series (17) are shifted relative to the ADC sampling pattern (18) with a defined number of first temporal shifts, wherein the number of first temporal shifts is set on the basis of at least one element of the following group:
• a defined minimum number of samplings of the at least one initial sampling point by each of the ADC conversion stages (22A, 22B, 22C, 22D) used,
• a defined measurement accuracy for the determination of the distance,
• a measured signal value of the reception signal, and
• a predefined measurement time.

11. The laser distance measuring module as claimed in any one of claims 8 to 10,
**wherein**
the laser distance measuring module is configured in such a way that the reception signals of the reception signal series (17) are shifted relative to the ADC sampling pattern (18) with a defined number of second temporal shifts, as a result of which the sampling range is sampled with a defined number of secondary sampling points (21), wherein the number of secondary sampling points is set on the basis of at least one element of the following group:
• a defined minimum number of mutually different secondary sampling points, in particular on the basis of a minimum number of samplings of each secondary sampling point by each of the ADC conversion stages (22A, 22B, 22C, 22D) used,
• a defined measurement accuracy for the determination of the distance,
• a measured signal value of the reception signal, and
• a predefined measurement time.

12. The laser distance measuring module as claimed in any one of claims 8 to 11,
**wherein**
the laser distance measuring module is configured in such a way that at least portions of the transmission signals as reference signals of a reference signal series (17) pass via a reference section having a known, invariable length and are digitized by means of the ADC, in particular by means of reflection at the target object at a known, invariable distance or without prior reflection at the target object, especially wherein the reference section extends completely within the laser distance measuring apparatus, wherein
• the ADC sampling pattern (18) defines with respect to a reference signal an initial reference sampling pattern (19) with at least one initial reference sampling point (20, 20A, 20B) of the reference signal, and
• the reference signals of the reference signal series (17) are shifted relative to the ADC sampling pattern (18) by means of the first temporal shift, such that the at least one initial reference sampling point (20, 20A, 20B) is detected at least once by the first ADC conversion stage (22A, 22B, 22C, 22D) and at least once by the second ADC conversion stage (22A, 22B, 22C, 22D),
in particular wherein the reference signals of the reference signal series (17) are additionally temporally shifted relative to the ADC sampling pattern (18) by means of the second temporal shift such that in a defined sampling range around the at least one initial reference sampling point (20, 20A, 20B) a multiplicity of secondary reference sampling points (21) of the reference signals arise, said secondary reference sampling points being shifted in each case by a fraction of the period duration of the ADC clock signal, and this results in the sampling of different signal positions around the at least one initial reference sampling point with a varying signal value,
wherein
• a reference transmission instant for the transmission signal series is derived on the basis of the digitized reference signals,
• a system transmission instant for the transmission signal series is derived on the basis of a system clock, and
• on the basis of the reference transmission instant and the system transmission instant reference time information for a determination of the first and/or second temporal shift is derived, which is taken into account during a determination of a reception instant of the reception signal series and/or the determination of the distance to the target object.

13. The laser distance measuring module as claimed in any one of claims 8 to 12,
**wherein**
the relative temporal shifts are generated
• by means of shifting the transmission instants of the transmission signals, and/or
• by means of shifting the sampling instants of the reception signals.

14. The laser distance measuring module as claimed in any one of claims 8 to 13,
**wherein**
• the transmission signals are emitted on the basis of a transmission clock and an initial relative emission instant of a transmission signal is defined relative to the transmission clock, and/or
• the reception signals are detected on the basis of a reception clock and an ADC clock for the control of the ADC for detecting a sequence of reception signals is defined by the reception clock,
wherein
• at least one secondary relative emission instant of the transmission signal that is temporally shifted with respect to the initial relative emission instant is generated by means of a first phase shifter, and/or
• the ADC clock is temporally shifted relative to the reception clock by means of a second phase shifter.

## Revendications

1. Procédé de mesure de distance, en particulier pour un appareil de mesure de distance par laser, notamment réalisé sous la forme d'un laser de poursuite, d'un tachymètre, d'un scanner laser ou d'un profileur, pour déterminer une distance par rapport à un objet cible, comprenant
- une émission de signaux d'émission, en particulier de signaux d'émission puisés, sous la forme d'une série de signaux d'émission,
- une réception d'au moins des parties des signaux d'émission de la série de signaux d'émission réfléchis sur l'objet cible en tant que signaux de réception (16A, 16B) d'une série de signaux de réception (17),
- une numérisation des signaux de réception de la série de signaux de réception en signaux numériques (11, 14A, 14B) d'une série de signaux numériques au moyen d'un convertisseur analogique-numérique, ci-après dénommé ADC, en particulier du type ADC entrelacé ou ADC pipeline, ayant un motif d'échantillonnage ADC (18) produit par au moins deux étages de conversion ADC (22A, 22B, 22C, 22D) et
- un traitement de la série de signaux numériques afin d'en déduire la distance par rapport à l'objet cible, en particulier la détermination de la distance étant basée sur le procédé du temps de propagation des impulsions,
**caractérisé en ce que**
- le motif d'échantillonnage ADC (18) définit par rapport à un signal de réception un motif d'échantillonnage de signal initial (19) ayant au moins un point d'échantillonnage initial (20, 20A, 20B) du signal de réception et
- les signaux de réception de la série de signaux de réception (17) sont décalés dans le temps par rapport au motif d'échantillonnage ADC (18) au moyen d'un premier décalage temporel de telle sorte que ledit au moins un point d'échantillonnage initial (20, 20A, 20B) est détecté au moins une fois par un premier étage de conversion ADC (22A, 22B, 22C, 22D) et au moins une fois par un second étage de conversion ADC (22A, 22B, 22C, 22D),
en particulier les signaux de réception de la série de signaux de réception (17) étant en outre décalés dans le temps par rapport au motif d'échantillonnage ADC (18) au moyen d'un second décalage temporel, que dans une plage d'échantillonnage définie autour dudit au moins un point d'échantillonnage initial (20, 20A, 20B) une pluralité de points d'échantillonnage secondaires (21) des signaux de réception sont formés, dont chacun est décalé d'une fraction de la durée de période de l'horloge ADC, et différentes positions de signal avec une valeur de signal variable sont ainsi échantillonnées autour dudit au moins un point d'échantillonnage initial (20, 20A, 20B).

2. Procédé de mesure de distance selon la revendication 1,
**caractérisé en ce que**
les signaux d'émission sont émis sur la base d'une horloge d'émission et les signaux de réception sont détectés sur la base d'une horloge ADC, au moins une des conditions suivantes étant remplie dans le cadre d'un processus de mesure :
- l'horloge d'émission est asynchrone par rapport à l'horloge ADC,
- la durée de période de l'horloge d'émission et/ou une durée de période des signaux d'émission est différente de la durée de période de l'horloge ADC ou d'un multiple entier de la durée de période de l'horloge ADC et
- la période d'émission Tₛ correspondant à la fréquence d'horloge d'émission et/ou à un taux de répétition des signaux d'émission est donnée par Tₛ = (n + q) * T_{ADC}, où n est un nombre entier, q est un nombre fractionnaire ayant une valeur absolue < 1 et T_{ADC} est la durée de période de l'horloge ADC, la condition n modulo c ≠ 0 étant remplie pour un nombre c d'étages de conversion ADC utilisés.

3. Procédé de mesure de distance selon l'une des revendications précédentes,
**caractérisé en ce que**
les signaux de réception de la série de signaux de réception (17) sont décalés par rapport au motif d'échantillonnage ADC (18) par un nombre défini de premiers décalages temporels, le nombre de premiers décalages temporels étant réglé sur la base d'au moins un élément du groupe suivant :
- un nombre minimal défini d'échantillonnages dudit au moins un point d'échantillonnage initial par chacun des étages de conversion ADC (22A, 22B, 22C, 22D) utilisés,
- une précision de mesure définie pour la détermination de la distance,
- une valeur de signal mesurée du signal de réception et
- un temps de mesure prédéfini.

4. Procédé de mesure de distance selon l'une des revendications précédentes,
**caractérisé en ce que**
les signaux de réception de la série de signaux de réception (17) sont décalés par rapport au motif d'échantillonnage ADC (18) par un nombre défini de seconds décalages temporels, de sorte que la plage d'échantillonnage est échantillonnée avec un nombre défini de points d'échantillonnage secondaires (21), le nombre de points d'échantillonnage secondaires étant réglé sur la base d'au moins un élément du groupe suivant :
- un nombre minimal défini de points d'échantillonnage secondaires mutuellement différents, en particulier sur la base d'un nombre minimal d'échantillonnages de chaque point d'échantillonnage secondaire par chacun des étages de conversion ADC (22A, 22B, 22C, 22D) utilisés,
- une précision de mesure définie pour la détermination de la distance,
- une valeur de signal mesurée du signal de réception et
- un temps de mesure prédéfini.

5. Procédé de mesure de distance selon l'une des revendications précédentes, **caractérisé en ce**
**qu'**au moins des parties des signaux d'émission s'étendent en tant que signaux de référence d'une série de signaux de référence (17) sur un trajet de référence de longueur connue invariable et sont numérisés au moyen de l'ADC, en particulier par réflexion sur l'objet cible à une distance connue invariable ou sans réflexion préalable sur l'objet cible, notamment le trajet de référence s'étendant complètement à l'intérieur de l'appareil de mesure de distance par laser, dans lequel
- le motif d'échantillonnage ADC (18) définit par rapport à un signal de référence un motif d'échantillonnage de référence initial (19) ayant au moins un point d'échantillonnage de référence initial (20, 20A, 20B) du signal de référence et
- les signaux de référence de la série de signaux de référence (17) sont décalés par rapport au motif d'échantillonnage ADC (18) au moyen du premier décalage temporel de telle sorte que ledit au moins un point d'échantillonnage de référence initial est détecté au moins une fois par le premier étage de conversion ADC (22A, 22B, 22C, 22D) et au moins une fois par le second étage de conversion ADC (22A, 22B, 22C, 22D),
en particulier les signaux de référence de la série de signaux de référence (17) étant en outre décalés dans le temps par rapport au motif d'échantillonnage ADC (18) au moyen du second décalage temporel, que dans une plage d'échantillonnage définie autour dudit au moins un point d'échantillonnage de référence initial (20, 20A, 20B) une pluralité de points d'échantillonnage de référence secondaires (21) des signaux de référence sont formés, dont chacun est décalé d'une fraction de la durée de période de l'horloge ADC, et différentes positions de signal sont ainsi échantillonnées avec une valeur de signal variable autour dudit au moins un point d'échantillonnage de référence initial,
dans lequel
- un instant d'émission de référence pour la série de signaux d'émission est dérivé sur la base des signaux de référence numérisés,
- un instant d'émission du système pour la série de signaux d'émission est dérivé sur la base d'une horloge du système et
- une information de temps de référence pour une détermination du premier et/ou du second décalage temporel est dérivée sur la base de l'instant d'émission de référence et de l'instant d'émission du système, qui est prise en compte pour la détermination d'un instant de réception de la série de signaux de réception et/ou pour la détermination de la distance par rapport à l'objet cible.

6. Procédé de mesure de distance selon l'une des revendications précédentes,
**caractérisé en ce que**
les décalages temporels relatifs sont produits
- en décalant les instants d'émission des signaux d'émission et/ou
- en décalant les instants d'échantillonnage des signaux de réception.

7. Procédé de mesure de distance selon l'une des revendications précédentes, **caractérisé en ce que**
- les signaux d'émission sont émis sur la base d'une horloge d'émission et un instant d'émission relatif initial d'un signal d'émission est défini par rapport à l'horloge d'émission et/ou
- les signaux de réception sont détectés sur la base d'une horloge de réception et une horloge ADC pour commander l'ADC afin de détecter une suite de signaux de réception est définie par l'horloge de réception,
dans lequel
- au moins un instant d'émission relatif secondaire du signal d'émission, décalé dans le temps par rapport à l'instant d'émission relatif initial, est produit au moyen d'un premier déphaseur et/ou
- l'horloge ADC est décalée dans le temps par rapport à l'horloge de réception au moyen d'un second déphaseur.

8. Module électronique de mesure de distance par laser, en particulier destiné à être utilisé dans un appareil de mesure de distance, notamment réalisé sous la forme d'un laser de poursuite, d'un tachymètre, d'un scanner laser ou d'un profileur, pour déterminer une distance par rapport à un objet cible, comprenant
- un canal d'émission optique avec une unité d'émission pour produire des signaux d'émission d'une série de signaux d'émission, en particulier au moyen d'un rayonnement laser de mesure pulsé,
- un canal de réception optique avec une unité de réception pour recevoir au moins des parties des signaux d'émission de la série de signaux d'émission réfléchis sur l'objet cible en tant que signaux de réception (16A, 16B) d'une série de signaux de réception (17),
- un circuit de réception pour numériser les signaux de réception de la série de signaux de réception en signaux numériques (11, 14A, 14B) d'une série de signaux numériques avec un convertisseur analogique-numérique, ci-après dénommé ADC, en particulier du type ADC entrelacé ou ADC pipeline, ayant un motif d'échantillonnage ADC (18) produit par au moins deux étages (22A, 22B, 22C, 22D) de conversion ADC et
- une unité de contrôle et de commande pour déterminer la distance par rapport à l'objet cible sur la base d'un traitement de la série de signaux numériques, en particulier la détermination de la distance étant basée sur le procédé du temps de propagation des impulsions,
**caractérisé en ce que**
le module de mesure de distance par laser est conçu de telle sorte que
- le motif d'échantillonnage ADC (18) définit par rapport à un signal de réception un motif d'échantillonnage de signal initial (19) ayant au moins un point d'échantillonnage initial (20, 20A, 20B) du signal de réception et
- les signaux de réception de la série de signaux de réception (17) sont décalés dans le temps par rapport au motif d'échantillonnage ADC (18) au moyen d'un premier décalage temporel de telle sorte que ledit au moins un point d'échantillonnage initial (20, 20A, 20B) est détecté au moins une fois par un premier étage de conversion ADC (22A, 22B, 22C, 22D) et au moins une fois par un second étage de conversion ADC (22A, 22B, 22C, 22D),
en particulier les signaux de réception de la série de signaux de réception (17) étant en outre décalés dans le temps par rapport au motif d'échantillonnage ADC (18) au moyen d'un second décalage temporel, que dans une plage d'échantillonnage définie autour dudit au moins un point d'échantillonnage initial (20, 20A, 20B) une pluralité de points d'échantillonnage secondaires (21) des signaux de réception sont formés, dont chacun est décalé d'une fraction de la durée de période de l'horloge ADC, et différentes positions de signal avec une valeur de signal variable sont ainsi échantillonnées autour dudit au moins un point d'échantillonnage initial (20, 20A, 20B).

9. Module de mesure de distance par laser selon la revendication 8,
**caractérisé en ce que**
le module de mesure de distance par laser est conçu de telle sorte que les signaux d'émission sont émis sur la base d'une horloge d'émission et les signaux de réception sont détectés sur la base d'une horloge ADC, au moins une des conditions suivantes étant remplie dans le cadre d'un processus de mesure :
- l'horloge d'émission est asynchrone par rapport à l'horloge ADC,
- la durée de période de l'horloge d'émission et/ou une durée de période des signaux d'émission est différente de la durée de période de l'horloge ADC ou d'un multiple entier de la durée de période de l'horloge ADC et
- la période d'émission Tₛ correspondant à la fréquence d'horloge d'émission et/ou à un taux de répétition des signaux d'émission est donnée par Tₛ = (n + q) * T_{ADC}, où n est un nombre entier, q est un nombre fractionnaire ayant une valeur absolue entre -1 et +1 et T_{ADC} est la durée de période de l'horloge ADC, la condition n modulo c ≠ 0 étant remplie pour un nombre c d'étages de conversion ADC utilisés.

10. Module de mesure de distance par laser selon la revendication 8 ou 9,
**caractérisé en ce que**
le module de mesure de distance par laser est conçu de telle sorte que les signaux de réception de la série de signaux de réception (17) sont décalés par rapport au motif d'échantillonnage ADC (18) par un nombre défini de premiers décalages temporels, le nombre de premiers décalages temporels étant réglé sur la base d'au moins un élément du groupe suivant :
- un nombre minimal défini d'échantillonnages dudit au moins un point d'échantillonnage initial par chacun des étages de conversion ADC (22A, 22B, 22C, 22D) utilisés,
- une précision de mesure définie pour la détermination de la distance,
- une valeur de signal mesurée du signal de réception et
- un temps de mesure prédéfini.

11. Module de mesure de distance par laser selon l'une des revendications 8 à 10,
**caractérisé en ce que**
le module de mesure de distance par laser est conçu de telle sorte que les signaux de réception de la série de signaux de réception (17) sont décalés par rapport au motif d'échantillonnage ADC (18) par un nombre défini de seconds décalages temporels, de sorte que la plage d'échantillonnage est échantillonnée avec un nombre défini de points d'échantillonnage secondaires (21), le nombre de points d'échantillonnage secondaires étant réglé sur la base d'au moins un élément du groupe suivant :
- un nombre minimal défini de points d'échantillonnage secondaires mutuellement différents, en particulier sur la base d'un nombre minimal d'échantillonnages de chaque point d'échantillonnage secondaire par chacun des étages de conversion ADC (22A, 22B, 22C, 22D) utilisés,
- une précision de mesure définie pour la détermination de la distance,
- une valeur de signal mesurée du signal de réception et
- un temps de mesure prédéfini.

12. Module de mesure de distance par laser selon l'une des revendications 8 à 11,
**caractérisé en ce que**
le module de mesure de distance par laser est conçu de telle sorte qu'au moins des parties des signaux d'émission s'étendent en tant que signaux de référence d'une série de signaux de référence (17) sur un trajet de référence de longueur connue invariable et sont numérisés au moyen de l'ADC, en particulier par réflexion sur l'objet cible à une distance connue invariable ou sans réflexion préalable sur l'objet cible, notamment le trajet de référence s'étendant complètement à l'intérieur de l'appareil de mesure de distance par laser, dans lequel
- le motif d'échantillonnage ADC (18) définit par rapport à un signal de référence un motif d'échantillonnage de référence initial (19) ayant au moins un point d'échantillonnage de référence initial (20, 20A, 20B) du signal de référence et
- les signaux de référence de la série de signaux de référence (17) sont décalés par rapport au motif d'échantillonnage ADC (18) au moyen du premier décalage temporel de telle sorte que ledit au moins un point d'échantillonnage de référence initial est détecté au moins une fois par le premier étage de conversion ADC (22A, 22B, 22C, 22D) et au moins une fois par le second étage de conversion ADC (22A, 22B, 22C, 22D),
en particulier les signaux de référence de la série de signaux de référence (17) étant en outre décalés dans le temps par rapport au motif d'échantillonnage ADC (18) au moyen du second décalage temporel, que dans une plage d'échantillonnage définie autour dudit au moins un point d'échantillonnage de référence initial (20, 20A, 20B) une pluralité de points d'échantillonnage de référence secondaires (21) des signaux de référence sont formés, dont chacun est décalé d'une fraction de la durée de période de l'horloge ADC, et différentes positions de signal sont ainsi échantillonnées avec une valeur de signal variable autour dudit au moins un point d'échantillonnage de référence initial,
dans lequel
- un instant d'émission de référence pour la série de signaux d'émission est dérivé sur la base des signaux de référence numérisés,
- un instant d'émission du système pour la série de signaux d'émission est dérivé sur la base d'une horloge du système et
- une information de temps de référence pour une détermination du premier et/ou du second décalage temporel est dérivée sur la base de l'instant d'émission de référence et de l'instant d'émission du système, qui est prise en compte pour la détermination d'un instant de réception de la série de signaux de réception et/ou pour la détermination de la distance par rapport à l'objet cible.

13. Module de mesure de distance par laser selon l'une des revendications 8 à 12,
**caractérisé en ce que**
les décalages temporels relatifs sont produits
- en décalant les instants d'émission des signaux d'émission et/ou
- en décalant les instants d'échantillonnage des signaux de réception.

14. Module de mesure de distance par laser selon l'une des revendications 8 à 13,
**caractérisé en ce que**
- les signaux d'émission sont émis sur la base d'une horloge d'émission et un instant d'émission relatif initial d'un signal d'émission est défini par rapport à l'horloge d'émission et/ou
- les signaux de réception sont détectés sur la base d'une horloge de réception et une horloge ADC pour commander l'ADC afin de détecter une suite de signaux de réception est définie par l'horloge de réception,
dans lequel
- au moins un instant d'émission relatif secondaire du signal d'émission, décalé dans le temps par rapport à l'instant d'émission relatif initial, est produit au moyen d'un premier déphaseur et/ou
- l'horloge ADC est décalée dans le temps par rapport à l'horloge de réception au moyen d'un second déphaseur.
